# EUROPEAN PATENT APPLICATION

(11) **EP 4 845 331 A1**
(43) Date of publication of application: **25.11.2026**
(21) Application number: 26166109.4
(22) Date of filing: 19.03.2026
(51) Int. Cl.: H10B 12/00, H10P 30/20

(54) **METHOD OF MANUFACTURING SEMICONDUCTOR DEVICES HAVING IMPLANTED IMPURITIES**

(30) Priority: 19.05.2025 KR 20250064429
(71) Applicant: Samsung Electronics Co., Ltd., Suwon-si, Gyeonggi-do 16677 (KR)
(72) Inventor: OH, Jeonghoon, 16677 Suwon-si (KR); LEE, Sangho, 16677 Suwon-si (KR); KIM, Junsoo, 16677 Suwon-si (KR)
(74) Representative: Marks & Clerk LLP

(57) **Abstract**

A method of manufacturing a semiconductor device includes forming a first semiconductor pattern on a semiconductor body and having a first side surface exposed by a first opening, the first semiconductor pattern including a lower region, a first intermediate region, a second intermediate region, and an upper region; forming a first impurity-implanted region in which the first impurities are implanted, where at least a portion of the first impurity-implanted region is formed in the semiconductor body below the first opening; forming a first impurity-diffused region in which the first impurities of the first impurity-implanted region are diffused and activated, where the first impurity-diffused region is formed in the semiconductor body, and the lower region and the first intermediate region; and forming a first source/drain region in which second impurities are diffused and activated in the upper region.

## Description

### BACKGROUND

The present disclosure relates to a method of manufacturing semiconductor devices. Research has been conducted to reduce the sizes of elements included in a semiconductor device and to improve performance thereof. For example, for a dynamic random-access memory (DRAM), research to reliably and stably form elements having reduced sizes has been conducted, but as the sizes of elements are reduced, properties of a semiconductor device may be deteriorated.

### SUMMARY

Some aspects of the present disclosure provide semiconductor devices having increased integration density, and methods of manufacture thereof.

According to some aspects of the present disclosure, a method of manufacturing a semiconductor device includes forming a first semiconductor pattern on a semiconductor body, wherein the first semiconductor pattern has a first side surface exposed by a first opening, and the first semiconductor pattern includes a lower region, a first intermediate region on the lower region, a second intermediate region on the first intermediate region, and an upper region on the second intermediate region; forming a first impurity-implanted region in which first impurities are implanted, wherein at least a portion of the first impurity-implanted region is formed in the semiconductor body below the first opening; forming a first impurity-diffused region in which the first impurities of the first impurity-implanted region are diffused and activated, wherein the first impurity-diffused region is formed in the semiconductor body, and the lower region and the first intermediate region of the first semiconductor pattern; and forming a first source/drain region in which second impurities are diffused and activated in the upper region of the first semiconductor pattern. The annealing the first impurity-implanted region may be subsequent to the implanting the first impurities.

According to some aspects of the present disclosure, a method of manufacturing a semiconductor device includes forming a semiconductor body, a first cell semiconductor pattern protruding upwardly from the semiconductor body and having a side surface exposed by a first opening, and a first dummy semiconductor pattern protruding upwardly from the semiconductor body and having a side surface exposed by a second opening; forming a first cell impurity-implanted region and a first dummy impurity-implanted region by performing a first impurity implantation process of implanting first impurities; and forming a first cell impurity-diffused region and a first dummy impurity-diffused region by performing a first source/drain annealing, wherein at least a portion of the first cell impurity-implanted region is formed by implanting the first impurities into the semiconductor body below the first opening, wherein at least a portion of the first dummy impurity-implanted region is formed by implanting the first impurities into the semiconductor body below the second opening, wherein the first cell impurity-diffused region is formed by diffusing and activating the first impurities in the first cell impurity-implanted region, wherein the first dummy impurity-diffused region is formed by diffusing and activating the first impurities in the first dummy impurity-implanted region, wherein the first cell impurity-diffused region is formed by being diffused from the semiconductor body into the first cell semiconductor pattern, and wherein the first dummy impurity-diffused region is formed by being diffused from the semiconductor body into the dummy semiconductor pattern.

According to some aspects of the present disclosure, a method of manufacturing a semiconductor device includes forming a first structure; forming a second structure including a peripheral circuit; and forming a bonded structure by bonding the first structure to the second structure by a wafer bonding process, wherein forming the first structure includes forming a structure including a semiconductor body, a first cell semiconductor pattern protruding upwardly from the semiconductor body, a first dummy semiconductor pattern protruding upwardly from the semiconductor body, a first impurity-diffused region of which at least a portion is formed in a lower region of the first cell semiconductor pattern, and a first dummy impurity-diffused region of which at least a portion is formed in a lower region of the first dummy semiconductor pattern; forming a first source/drain region in an upper region of the first cell semiconductor pattern; forming a data storage structure connected to the first source/drain region; removing a portion of the semiconductor body and the first cell semiconductor pattern, wherein the first cell semiconductor pattern is formed as a cell semiconductor pattern, and the first impurity-diffused region remains in the cell semiconductor pattern and is formed as a second source/drain region; and forming a bit line connected to the second source/drain region.

At least some of the above and other features of the disclosure are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a perspective diagram illustrating an example of a semiconductor device;
FIG. 2 is a top view diagram illustrating regions of an example of a semiconductor device;
FIG. 3 is a cross-sectional diagram illustrating regions of the semiconductor device of FIG. 2.
FIG. 4 is a cross-sectional diagram illustrating an example of a semiconductor device;
FIGS. 5A, 5B, 5C, 5D, 5E, and 5F are cross-sectional diagrams illustrating respective examples of a semiconductor device;
FIG. 6 is a flowchart illustrating an example of a method of manufacturing a semiconductor device;
FIGS. 7, 8, 9, 10, 11, 12, 13A, 13B, 14A, 14B, 15, 16, 17, 18, 19, and 20 are cross-sectional diagrams illustrating examples of methods of manufacturing a semiconductor device;
FIGS. 21, 22, and 23 are cross-sectional diagrams illustrating an example of a method of manufacturing a semiconductor device;
FIGS. 24, and 25 are cross-sectional diagrams illustrating an example of a method of manufacturing a semiconductor device; and
FIGS. 26, 27, and 28 are cross-sectional diagrams illustrating an example of a method of manufacturing a semiconductor device.

### DETAILED DESCRIPTION

In the following disclosure, the terms such as "upper," "lower," "preliminary," or the like, may be replaced with other terms, such as "first," "second," and "third," or the like. The terms such as "upper," "lower," "preliminary," or the like, may be used to describe various elements, but the elements are not limited by the terms, and a "first element" may equally be denoted as a "second element," without implication of any ordering, etc. For example, a "preliminary cell semiconductor pattern" may also be denoted as a "first cell semiconductor pattern."

The terms "upper," "lower," and the like, are used with respect to the orientations of the drawings.

An "impurity-implanted region" is defined as a region in which impurities are doped into the semiconductor and source/drain annealing to form a source/drain region has not been performed thereon. An "impurity-diffused region" and "source/drain region" are defined as regions formed by diffusing and activating impurities in the impurity-implanted region by source/drain annealing.

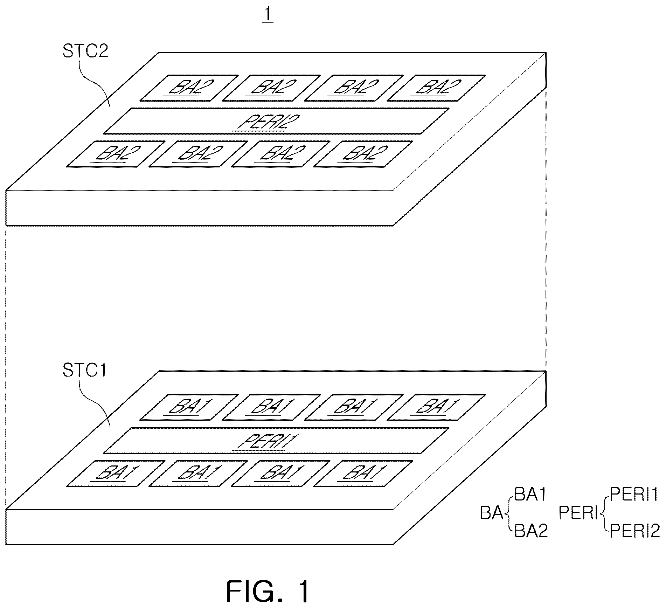

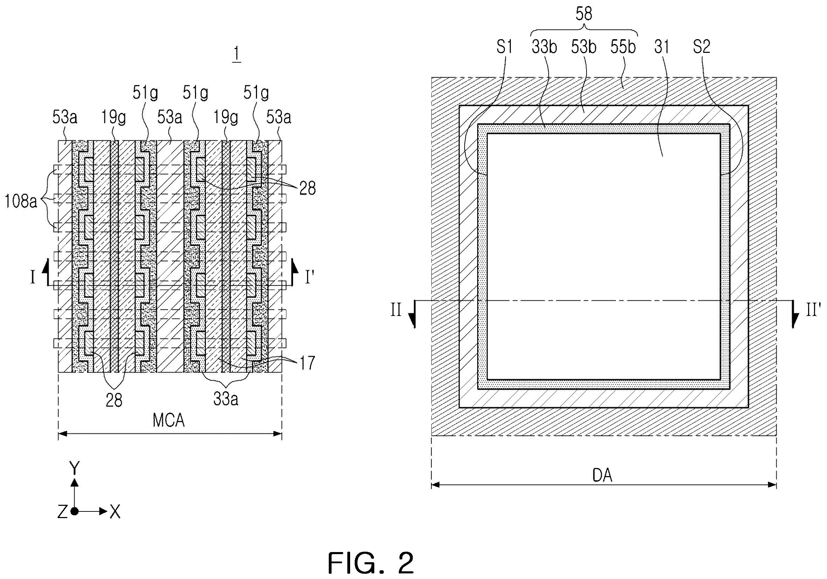

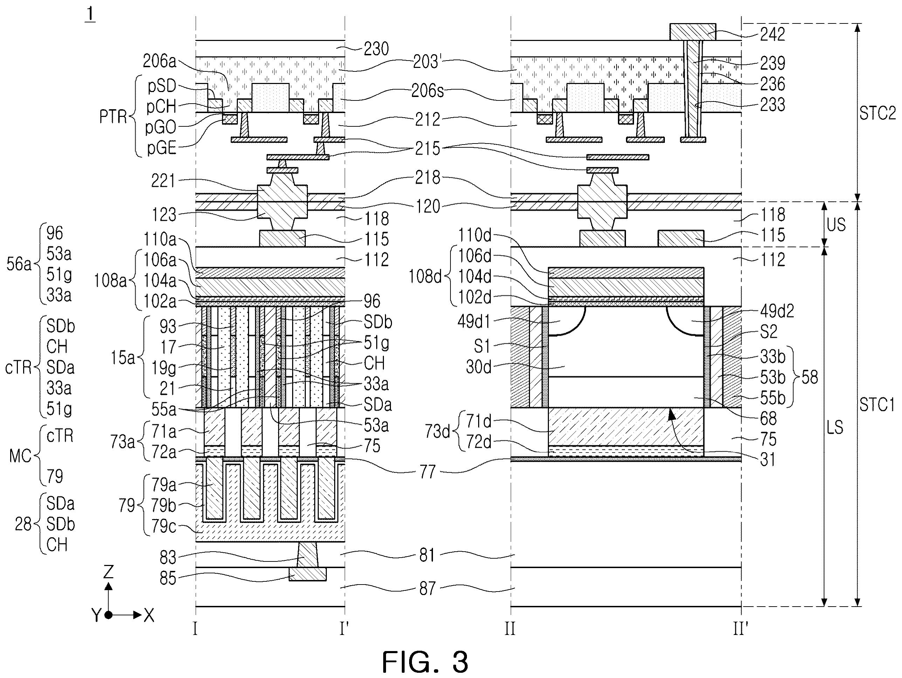

An example of a semiconductor device will be described with reference to FIGS. 1, 2, and 3. In FIGS. 1 to 3, FIG. 1 is a perspective diagram illustrating the semiconductor device, FIG. 2 is a plan diagram illustrating a memory cell array region MCA and a dummy region DA of a first semiconductor structure of the semiconductor device, and FIG. 3 is a cross-sectional diagram illustrating regions taken along lines I-I' and II-II' in FIG. 2.

Referring to FIGS. 1, 2, and 3, a semiconductor device 1 may include a first semiconductor structure STC1 and a second semiconductor structure STC2 vertically overlapping the first semiconductor structure STC1. The second semiconductor structure STC2 may be disposed on the first semiconductor structure STC1. In some implementations, the second semiconductor structure STC2 may be disposed below the first semiconductor structure STC1.

The semiconductor device 1 may include a plurality of banks BA and a peripheral region PERI. The peripheral region PERI may include a first peripheral region PERI1 in the first semiconductor structure STC1 and a second peripheral region PERI2 in the second semiconductor structure STC2. The peripheral region PERI may be a peripheral region in which peripheral circuits for input/output of data or commands, or input of power/ground are disposed.

Each of the plurality of banks BA may include a first bank region BA1 in the first semiconductor structure STC1 and a second bank region BA2 in the second semiconductor structure STC2.

The first bank region BA1 of the first semiconductor structure STC1 may include a memory cell array region MCA in which memory cells (MC in FIG. 3) are disposed. The second bank region BA2 in the second semiconductor structure STC2 may include regions in which circuits used for operation of the memory cells MC are disposed. For example, the second bank region BA2 may include a sense amplifier region in which sense amplifiers for reading data of the memory cells MC are disposed, a sub-word line driver region in which sub-word line drivers for activating or deactivating the memory cells MC are disposed, and a peripheral circuit region for controlling at least one circuit among the circuits of the sense amplifier region and the sub-word line driver region.

The first peripheral region PERI1 in the first semiconductor structure STC1 may include a dummy region (DA in FIG. 2).

The first semiconductor structure STC1 may include a lower structure LS and an upper structure US on the lower structure LS, as shown in FIG. 3.

The lower structure LS may include cell semiconductor patterns 28 disposed in the memory cell array region MCA and dummy semiconductor patterns 31 disposed in the dummy region DA. A width of the dummy semiconductor pattern 31 may be greater than a width of each of the cell semiconductor patterns 28 in the first horizontal direction X. The width of the dummy semiconductor pattern 31 may be greater than the width of each of the cell semiconductor patterns 28 in the second horizontal direction Y which is perpendicular to the first horizontal direction X.

The cell semiconductor patterns 28 and the dummy semiconductor pattern 31 may be formed of single-crystal semiconductor. For example, the cell semiconductor patterns 28 and the dummy semiconductor pattern 31 may be formed of single-crystal silicon.

Each of the cell semiconductor patterns 28 may include a first source/drain region SDa and a second source/drain region SDb spaced apart from each other in the vertical direction Z, and a channel region CH between the second source/drain region SDb and the first source/drain region SDa. The second source/drain region SDb may be disposed on the first source/drain region SDa. In each of the cell semiconductor patterns 28, the second source/drain region SDb may be disposed on the first source/drain region SDa.

In some implementations, the second source/drain region SDb and the first source/drain region SDa may be formed by diffusing and activating the same element. For example, the second source/drain region SDb and the first source/drain region SDa may include at least one of phosphorus (P) and arsenic (As).

In some implementations, the second source/drain region SDb and the first source/drain region SDa may include different elements. For example, a major impurity of the second source/drain region SDb may be arsenic (As), and a major impurity of the first source/drain region SDa may be phosphorus (P). For example, the second source/drain region SDb may be formed by diffusing and activating arsenic (As), and the first source/drain region SDa may be formed by diffusing and activating phosphorus (P). As another example, a major impurity of the second source/drain region SDb may be phosphorus (P), and a major impurity of the first source/drain region SDa may be arsenic (As). For example, the second source/drain region SDb may be formed by diffusion and activation of phosphorus (P), and the first source/drain region SDa may be formed by diffusion and activation of arsenic (As). "Major" can refer to the primary impurity, e.g., an impurity constituting a majority of impurities present in a region.

In some implementations, the dummy semiconductor pattern 31 may include a first dummy source/drain region 68 and second dummy source/drain regions 49d1 and 49d2.

In the dummy semiconductor pattern 31, a region other than the second dummy source/drain region 49d1 and 49d2 and the first dummy source/drain region 68 may be an undoped dummy region 30d.

At least a portion of the first dummy source/drain region 68 may be disposed at the same level as the first source/drain regions SDa.

At least a portion of the second dummy source/drain regions 49d1 and 49d2 may be disposed at the same level as the second source/drain regions SDb.

The dummy semiconductor pattern 31 may have a first side surface S1 and a second side surface S2 opposing each other in the first horizontal direction X, and the second dummy source/drain region 49d1 and 49d2 may include a first dummy impurity region 49d1 disposed in the dummy semiconductor pattern 31 adjacent to the first side surface S1 and a second dummy impurity region 49d2 disposed in the dummy semiconductor pattern 31 adjacent to the second side surface S2. The undoped dummy region 30d may include a portion disposed between the first dummy impurity region 49d1 and the second dummy impurity region 49d2.

In some implementations, the first dummy impurity region 49d1 may be spaced apart from the second dummy impurity region 49d2 in the first horizontal direction X.

In some implementations, the first dummy impurity region 49d1 and the second dummy impurity region 49d2 may have a symmetrical structure in the first horizontal direction X.

In some implementations, the first dummy source/drain region 68 may extend from the first side surface S1 to the second side surface S2 in the first horizontal direction X.

In some implementations, a concentration of impurity of the first dummy impurity region 49d1 adjacent to the second dummy impurity region 49d2 may be lower than a concentration of impurity of the first dummy impurity region 49d1 adjacent to the first side surface S1. The concentration of impurity of the second dummy impurity region 49d2 adjacent to the first dummy impurity region 49d1 may be lower than a concentration of impurity of the second dummy impurity region 49d2 adjacent to the second side surface S2.

In some implementations, at least one of the concentration of impurity of the first dummy impurity region 49d1 and the concentration of impurity of the second dummy impurity region 49d2 may be different from the concentration of impurity of the second source/drain regions SDb. For example, at least one of the concentration of impurity of the first dummy impurity region 49d1 and the concentration of impurity of the second dummy impurity region 49d2 may be higher than the concentration of impurity of the second source/drain regions SDb.

The lower structure LS may further include gate structures 56a and insulating structures 58. Each of the gate structures 56a may pass between a pair of cell semiconductor patterns 28 adjacent to each other in the first horizontal direction X. Each of the gate structures 56a may include gate dielectric layers 33a, first gate capping insulating layers 55a, second gate capping insulating layers 96, first insulating pattern 53a, and gate electrodes 51g. In each of the gate structures 56a, the first insulating pattern 53a may pass between the pair of cell semiconductor patterns 28, the gate dielectric layers 33a may be in contact with side surfaces of the pair of cell semiconductor patterns 28 and may be disposed between the pair of cell semiconductor patterns 28 and the first insulating pattern 53a, the cell gate electrodes 51g may be disposed between the gate dielectric layers 33a and the first insulating pattern 53a, the first gate capping insulating layers 55a may be disposed between the gate dielectric layers 33a and the first insulating pattern 53a below the cell gate electrodes 51g, and the second gate capping insulating layers 96 may be disposed between the gate dielectric layers 33a and the first insulating pattern 53a on the cell gate electrodes 51g.

Each of the cell gate electrodes 51g may oppose the channel region CH of an adjacent cell semiconductor pattern 28 among the cell semiconductor patterns 28. For example, each cell gate electrode 51g may overlap an adjacent channel region CH along the first horizontal direction X (be at a same level as the adjacent channel region CH) with a gate dielectric layer 33a in-between. Each of the cell gate electrodes 51g may extend in the second horizontal direction Y.

The insulating structure 58 may include at least the peripheral dielectric layer 33b covering a side surface of the dummy semiconductor pattern 31, an insulating liner 53b covering a surface of the peripheral dielectric layer 33b, and a second insulating pattern 55b on the insulating liner 53b.

The first insulating pattern 53a and the insulating liner 53b may be formed of a first insulating material, and the second insulating pattern 55b may be formed of a second insulating material different from the first insulating material. For example, the first insulating pattern 53a and the insulating liner 53b may be formed of silicon oxide, and the second insulating pattern 55b may be formed of silicon nitride.

The lower structure LS may further include back gate structures 15a. The back gate structures 15a may be alternately arranged with the gate structures 56a in the first horizontal direction X. The first horizontal direction X and the second horizontal direction Y may be perpendicular to the vertical direction Z. The cell semiconductor patterns 28 may be disposed between the back gate structures 15a and the gate structures 56a. Each of the back gate structures 15a may include a back gate dielectric layer 17 in contact with a pair of cell semiconductor patterns 28 adjacent to each other in the first horizontal direction X, a back gate electrode 19g disposed between the back gate dielectric layers 17 and passing between the pair of cell semiconductor patterns 28, a first back gate capping insulating layer 21 disposed below the back gate electrode 19g, and a second back gate capping insulating layer 93 disposed on the back gate electrode 19g. The back gate electrode 19g may extend in the second horizontal direction Y.

The lower structure LS may include cell transistors cTR disposed in the memory cell array region MCA. Each of the cell transistors cTR may include the second source/drain region SDb, the first source/drain region SDa, the channel region CH, the cell gate dielectric layer 33a, and the cell gate electrode 51g. The cell gate electrode 51g may be a word line.

The cell gate electrode 51g and the back gate electrode 19g adjacent to each other may oppose each other with the channel region CH of the cell semiconductor pattern 28 interposed therebetween.

The lower structure LS may further include contact patterns 73a and 73d. The contact patterns 73a and 73d may include cell contact patterns 73a disposed below the cell semiconductor patterns 28 and connected to the first source/drain regions SDa of the cell semiconductor patterns 28, and a dummy contact pattern 73d disposed below the dummy semiconductor pattern 31 and connected to the dummy semiconductor pattern 31.

Each of the cell contact patterns 73a may include a first doped polysilicon layer 71a and a first conductive layer 72a disposed below the first doped polysilicon layer 71a. The dummy contact pattern 73d may include a dummy doped polysilicon layer 71d and a dummy conductive layer 72d disposed below the dummy doped polysilicon layer 71d.

The lower structure LS may further include an interlayer insulating layer 75 disposed on side surfaces of the cell contact patterns 73a and 73d.

The lower structure LS may further include an insulating etching stop layer 77 disposed below the cell contact patterns 73a and 73d and the interlayer insulating layer 75.

The lower structure LS may further include a data storage structure 79. The data storage structure 79 may include first electrodes 79a penetrating the etching stop layer 77, connected to the cell contact patterns 73a and extending downwardly, a dielectric layer 79b covering the first electrodes 79a and the etching stop layer 77, and a second electrode 79c covering the dielectric layer 79b. The data storage structure 79 may be cell capacitors storing data in a memory such as a DRAM.

The data storage structure 79 and the cell transistors cTR may be included in the memory cells MC of a memory such as a DRAM.

The lower structure LS may further include a first insulating layer 81 disposed below the data storage structure 79 and the etching stop layer 77, a contact plug 83 penetrating the first insulating layer 81 and connected to the second electrode 79c, an interconnection 85 connected to the contact plug 83 below the first insulating layer 81, and a lower insulating layer 87 disposed below the first insulating layer 81 and the interconnection 85.

The lower structure LS may further include bit lines 108a on the cell semiconductor patterns 28 and a dummy conductive pattern 108d on the dummy semiconductor pattern 31.

The bit lines 108a may be connected to the cell semiconductor patterns 28. The bit lines 108a may be electrically connected to the second source/drain regions SDb of the cell semiconductor patterns 28. The dummy conductive pattern 108d may be connected to the dummy semiconductor pattern 31.

Each of the bit lines 108a may include a first material layer 102a, a second material layer 104a, and a third material layer 106a, stacked in order. The dummy conductive pattern 108d may include a first material layer 102d, a second material layer 104d, and a third material layer 106d, stacked in order. The first material layers 102a and 102d may include doped polysilicon. The second material layers 104a and 104d may include at least one of a metal nitride and a metal-semiconductor compound. The third material layers 106a and 106d may include a metal.

The lower structure LS may further include bit line capping patterns 110a on upper surfaces of the bit lines 108a and dummy capping pattern 110d on upper surfaces of the dummy conductive pattern 108d.

The lower structure LS may further include a first intermediate insulating layer 112 covering the bit lines 108a, the dummy conductive pattern 108d, the bit line capping patterns 110a, and the dummy capping pattern 110d.

The upper structure US may include routing interconnections 115 on the first intermediate insulating layer 112, a second intermediate insulating layer 118 covering the routing interconnections 115, and a first bonding dielectric layer 120 on the second intermediate insulating layer 118.

In some implementations, the first bonding dielectric layer 120 may include at least one of SiO, SiN, SiCN, SiOC, SiON, or SiOCN.

The upper structure US may further include a first bonding pad 123 having an upper surface coplanar with the first bonding dielectric layer 120 and electrically connected to the routing interconnections 115. The first bonding pad 123 may include a metal material, for example, copper (Cu).

The second semiconductor structure STC2 may include peripheral transistors PTR. Each of the peripheral transistors PTR may include peripheral source/drain regions pSD, a peripheral channel region pCH between the peripheral source/drain regions pSD, a peripheral gate electrode pGE on the peripheral channel region pCH, and a peripheral gate dielectric layer pGO between the peripheral channel region pCH and the peripheral gate electrode pGE.

The second semiconductor structure STC2 may include an upper substrate 203', peripheral device isolation regions 206s defining peripheral active regions 206a below the upper substrate 203', an upper insulating layer 212 covering the peripheral transistors PTR below the upper substrate 203', an upper interconnection structure 215 buried in the upper insulating layer 212 and electrically connected to the peripheral transistors PTR, a second bonding dielectric layer 218 disposed below the upper insulating layer 212, and second bonding pads 221.

In each of the peripheral transistors PTR, the peripheral source/drain regions pSD and the peripheral channel region pCH may be formed in a corresponding peripheral active region 206a among the peripheral active regions 206a, and the peripheral gate dielectric layer pGO and the peripheral gate electrode pGE may be formed below the peripheral channel region pCH in the peripheral active region 206a.

The second bonding pads 221 may include a metal material, for example, copper (Cu). The second bonding pads 221 may have upper surfaces coplanar with each other with an upper surface of the second bonding dielectric layer 218 and may be electrically connected to the upper interconnection structure 215.

In some implementations, the second bonding dielectric layer 218 may include at least one of SiO, SiN, SiCN, SiOC, SiON, or SiOCN.

The second semiconductor structure STC2 may further include a capping insulating layer 230 disposed on the upper substrate 203', conductive vias 239 disposed in a hole 233 penetrating the capping insulating layer 230 and the upper substrate 203' and electrically connected to the upper interconnection structure 215, insulating spacers 236 on side surfaces of the conductive vias 239, and input/output pads 242 disposed on the conductive vias 239.

The first semiconductor structure STC1 and the second semiconductor structure STC2 may be bonded to each other by a hybrid bonding process including metal-metal bonding and dielectric-dielectric bonding. For example, the first bonding pads 123 and the second bonding pads 221 may be bonded to each other by a hybrid bonding process, and the first bonding dielectric layer 120 and the second bonding dielectric layer 218 may be bonded, thereby forming a bonded region.

Hereinafter, various examples of the semiconductor device 1 will be described. It will be understood that the features of the example of FIGS. 1 to 3 and the features of the below-described examples can be combined. Hereinafter, elements described above may be directly referred to with limited or no description, with the understanding that the above-provided description equally or similarly applies below. Also, elements described below which may be modified or replaced may be described with reference to the figures below, but elements which may be modified, replaced, or added may be combined with each other or with the elements described above to form a semiconductor device.

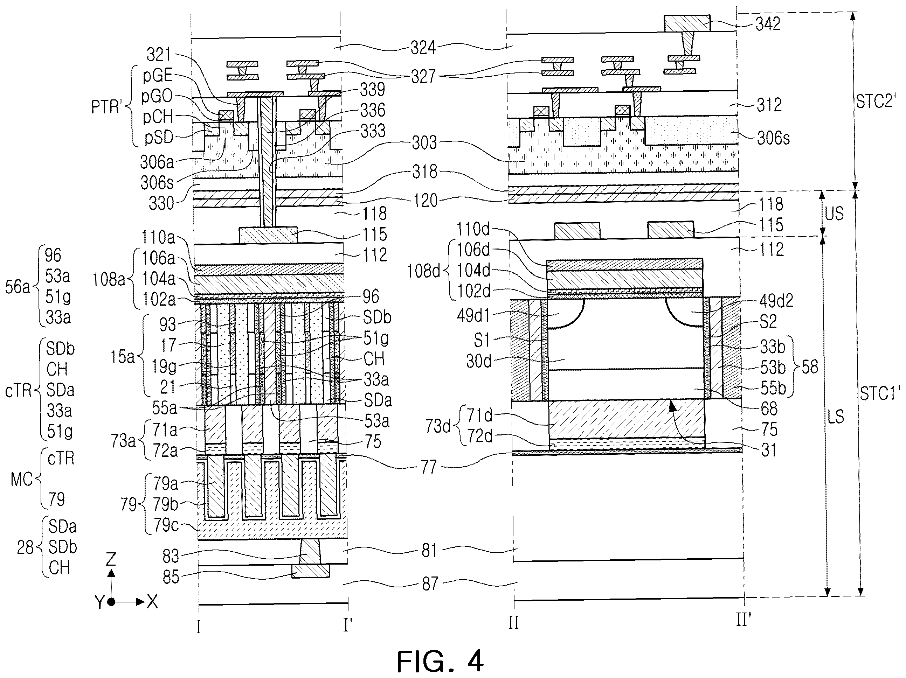

An example of the semiconductor device 1 will be described with reference to FIG. 4. FIG. 4 is a cross-sectional diagram illustrating regions taken along lines I-I' and II-II' in FIG. 2, illustrating a modified example of FIG. 3.

Referring to FIG. 4, the first semiconductor structure (STC1 in FIG. 3) described above may be replaced with a first semiconductor structure STC1' not including the first bonding pads (123 in FIG. 3).

The second semiconductor structure (STC2 in FIG. 3) described above may be replaced with a second semiconductor structure STC2' as in FIG. 4.

In some implementations, the second semiconductor structure STC2' may include an upper substrate 303, peripheral device isolation regions 306s defining peripheral active regions 306a on the upper substrate 303, a front insulating layer 312 covering the peripheral transistors PTR' on the upper substrate 303, a backside insulating layer 330 disposed below the upper substrate 303, and a second bonding dielectric layer 318 disposed below the backside insulating layer 330.

In each of the peripheral transistors PTR', the peripheral source/drain regions pSD and the peripheral channel region pCH may be disposed in a corresponding peripheral active region 306a among the peripheral active regions 306a, and the peripheral gate dielectric layer pGO and the peripheral gate electrode pGE may be disposed on the peripheral channel region pCH in the peripheral active region 306a.

In some implementations, the second bonding dielectric layer 318 may include at least one of SiO, SiN, SiCN, SiOC, SiON, or SiOCN.

The first bonding dielectric layer 120 and the second bonding dielectric layer 318 may be bonded to each other by a dielectric-dielectric bonding process. The first bonding dielectric layer 120 and the second bonding dielectric layer 318 may be bonded to each other by a dielectric-dielectric bonding process, thereby forming a bonded region.

The second semiconductor structure STC2' may further include conductive vias 339 disposed in a hole penetrating the front insulating layer 312 and the upper substrate 303 and extending downwardly, and electrically connected to the routing interconnections 115, and insulating spacers 336 disposed on side surfaces of the conductive vias 339.

The second semiconductor structure STC2' may further include contact plugs 321 penetrating the front insulating layer 312 and electrically connected to the peripheral transistors PTR'.

The second semiconductor structure STC2' may further include an upper insulating layer 324 on the front insulating layer 312, an upper interconnection structure 327 buried in the upper insulating layer 324, and input/output pads 342 electrically connected to the upper interconnection structure 327.

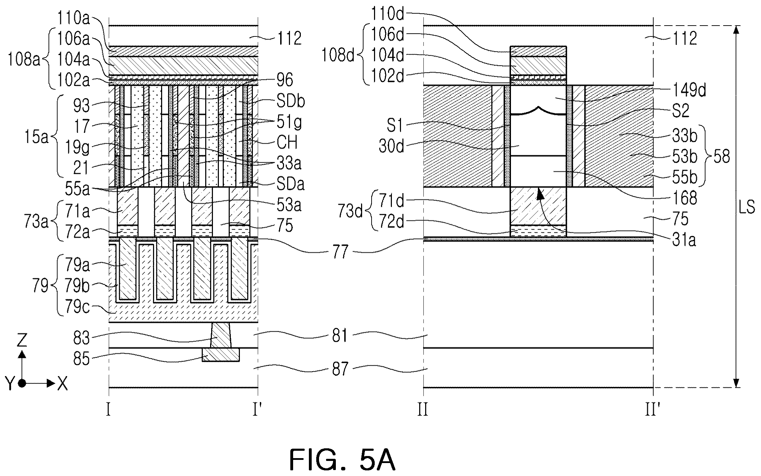

Another example of the semiconductor device 1 will be described with reference to FIG. 5A. FIG. 5A is a cross-sectional diagram illustrating regions taken along lines I-I' and II-II' in FIG. 2, illustrating a modified example of the lower structure LS in FIG. 3 or FIG. 4.

Referring to FIG. 5A, the dummy semiconductor pattern (31 in FIG. 3 or FIG. 4) described above may be replaced with a dummy semiconductor pattern 31a having a reduced width. The dummy semiconductor pattern 31a may have a first side surface S1 and a second side surface S2 corresponding to each other in the first horizontal direction X.

The second dummy source/drain region (49d1 and 49d2 in FIG. 3 or FIG. 4) described above may be replaced with a second dummy source/drain region 149d disposed in the dummy semiconductor pattern 31a. The first dummy source/drain region (68 in FIG. 3 or FIG. 4) described above may be replaced with a first dummy source/drain region 168 disposed in the dummy semiconductor pattern 31a.

The second dummy source/drain region 149d may extend from the first side surface S1 to the second side surface S2.

In the second dummy source/drain region 149d, a vertical thickness in the regions adjacent to the first and second side surfaces S1 and S2 may be greater than a vertical thickness in a middle region between the first and second side surfaces S1 and S2.

In the second dummy source/drain region 149d, a concentration of impurity of regions adjacent to the first and second side surfaces S1 and S2 may be higher than a concentration of impurity of the middle region between the first and second side surfaces S1 and S2.

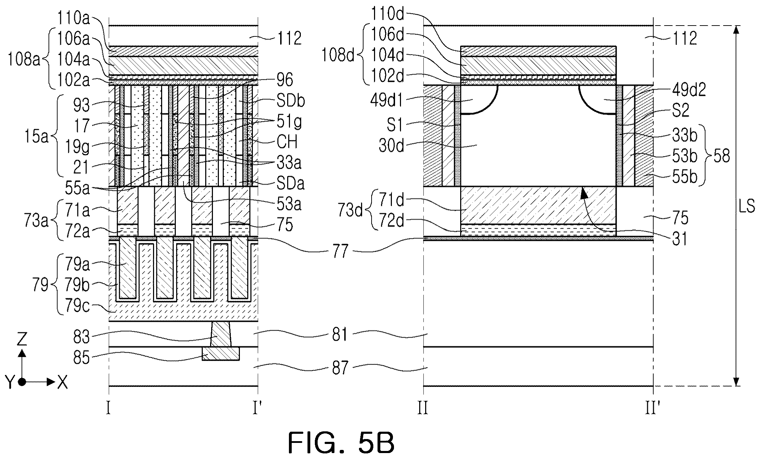

Another example of the semiconductor device 1 will be described with reference to FIG. 5B. FIG. 5B is a cross-sectional diagram illustrating regions taken along lines I-I' and II-II' in FIG. 2, illustrating a modified example of the lower structure LS in FIG. 3, FIG. 4, or FIG. 5A.

Referring to FIG. 5B, in the dummy semiconductor pattern (31 in FIG. 3, FIG. 4, or 31a in FIG. 5A) described above, the first dummy source/drain region (68 in FIG. 3, FIG. 4, or 168 in FIG. 5A) may not be provided.

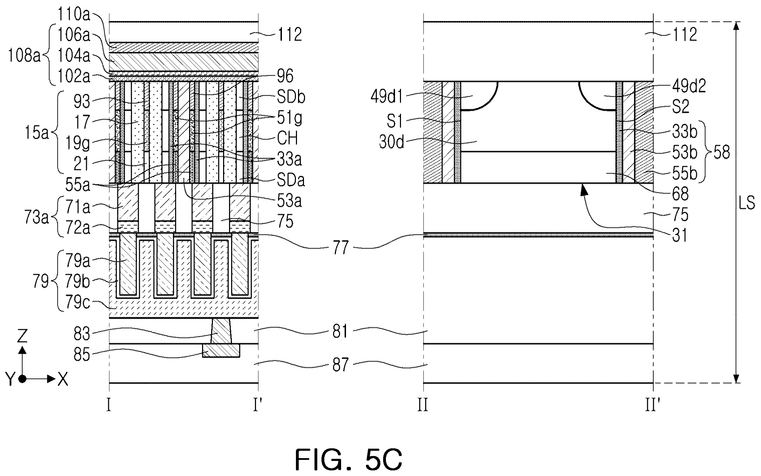

Another example of the semiconductor device 1 will be described with reference to FIG. 5C. FIG. 5C is a cross-sectional diagram illustrating regions taken along lines I-I' and II-II' in FIG. 2, illustrating a modified example of the lower structure LS in FIG. 3, FIG. 4, FIG. 5A, or FIG. 5B.

Referring to FIG. 5C, at least one of the dummy contact pattern 73d and the dummy conductive pattern 108d described above may not be provided. For example, only one of the dummy contact pattern 73d and the dummy conductive pattern 108d may not be provided, or both may not be provided. In the case in which the dummy contact pattern 73d is not provided, a lower surface of the dummy semiconductor pattern 31 may be in contact with the interlayer insulating layer 75. In the case in which the dummy conductive pattern 108d is not provided, an upper surface of the dummy semiconductor pattern 31 may be in contact with the first intermediate insulating layer 112.

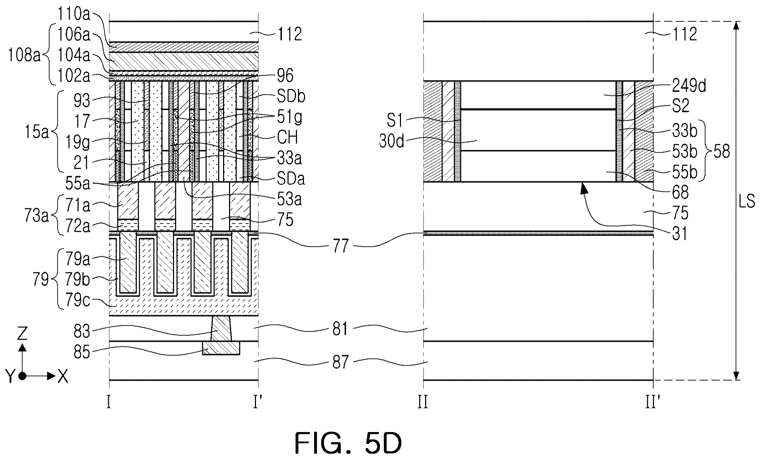

Another example of the semiconductor device 1 will be described with reference to FIG. 5D. FIG. 5D is a cross-sectional diagram illustrating regions taken along lines I-I' and II-II' in FIG. 2, illustrating a modified example of the lower structure LS in FIGS. 3, 4, 5A, 5B, and 5C.

Referring to FIG. 5D, the second dummy source/drain regions 49d1, 49d2, and 149d described above may be replaced with a second dummy source/drain region 249d having a substantially uniform vertical thickness. For example, in the second dummy source/drain region 249d, a vertical thickness in the regions adjacent to the first and second side surfaces S1 and S2 of the dummy semiconductor pattern 31 and a vertical thickness in a middle region between the first and second side surfaces S1 and S2 may be substantially the same.

At least a portion of the second dummy source/drain region 249d may be disposed at the same level as the second source/drain regions SDb.

The second dummy source/drain region 249d and the second source/drain regions SDb may be formed by doping with the same impurity element. For example, the major impurities of the second dummy source/drain region 249d and the second source/drain regions SDb may be the same element. For example, the major impurities of the second dummy source/drain region 249d and the second source/drain regions SDb may be phosphorus (P) or arsenic (As).

In some implementations, a concentration of impurity of the second dummy source/drain region 249d may be different from a concentration of impurities of the second source/drain regions SDb.

In some implementations, a concentration of impurity of the second dummy source/drain region 249d may be higher than a concentration of impurities in the second source/drain regions SDb.

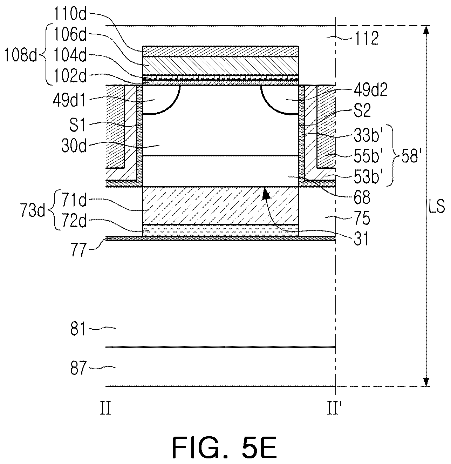

Another example of the semiconductor device 1 will be described with reference to FIG. 5E. FIG. 5E is a cross-sectional diagram illustrating a region taken along line II-II' in FIG. 2, illustrating a modified example of the insulating structure 58 of the lower structure LS in FIGS. 3, 4, 5A, 5B, 5C, and 5D. Here, FIG. 5E illustrates a modified example of the insulating structure 58 of the lower structure LS in the region taken along II-II' in FIG. 2.

Referring to FIG. 5E, the insulating structure 58 in FIGS. 3, 4, 5A, 5B, 5C, and 5D may be replaced with an insulating structure 58' as in FIG. 5E. For example, in the peripheral dielectric layer 33b, the insulating liner 53b, and the second insulating pattern 55b as in FIGS. 3, 4, 5A, 5B, 5C, and 5D, the insulating pattern (e.g., 55b in FIG. 3) may be replaced with an insulating pattern 55b' spaced apart from the interlayer insulating layer 75, and the insulating liner (e.g., 53b in FIG. 3) may be replaced with an insulating liner 53b' extending between a lower surface of the second insulating pattern 55b' and the interlayer insulating layer 75 from a portion disposed between a side surface of the dummy semiconductor pattern 31 and the second insulating pattern 55b', and the peripheral dielectric layer (e.g., 33b in FIG. 3) may be replaced with a peripheral dielectric layer 33b' extending between the insulating liner 53b' and the interlayer insulating layer 75 from a portion disposed between the side surface of the dummy semiconductor pattern 31 and the insulating liner 53b'. The insulating structure 58' may include the peripheral dielectric layer 33b', the insulating liner 53b', and the insulating pattern 55b'.

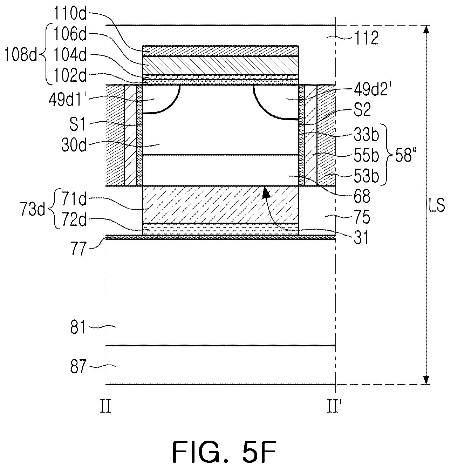

Another example of the semiconductor device 1 will be described with reference to FIG. 5F. FIG. 5F is a cross-sectional diagram illustrating a region taken along the line II-II' in FIG. 2, illustrating a modified example of the second dummy source/drain region 49d1 and 49d2 of the lower structure LS of the region taken along II-II' in FIG. 2.

Referring to FIG. 5F, the second dummy source/drain region 49d1 and 49d2 described above may be replaced with the second dummy source/drain region 49d1' and 49d2' having an asymmetric structure. The second dummy source/drain region 49d1' and 49d2' may include a first dummy impurity region 49d1' and a second dummy impurity region 49d2' spaced apart from each other in the first horizontal direction X.

In some implementations, the first dummy impurity region 49d1 and the second dummy impurity region 49d2 having a symmetrical structure in the first horizontal direction X described above may be replaced with the first dummy impurity region 49d1' and the second dummy impurity region 49d2' having an asymmetrical structure.

In some implementations, the first dummy impurity region 49d1 and the second dummy impurity region 49d2 having substantially the same width in the first horizontal direction X as in FIG. 3 may be replaced with the first dummy impurity region 49d1' and the second dummy impurity region 49d2' having different widths in the first horizontal direction X as in FIG. 5F

In some implementations, a width in the first horizontal direction X of the second dummy impurity region 49d2' may be greater than a width in the first horizontal direction X of the first dummy impurity region 49d1'.

In some implementations, the first dummy impurity region 49d1 and the second dummy impurity region 49d2 having substantially the same thickness in the vertical direction Z as in FIG. 3 may be replaced with the first dummy impurity region 49d1' and the second dummy impurity region 49d2' having different thicknesses in the vertical direction Z as in FIG. 5F.

In some implementations, a thickness of the second dummy impurity region 49d2' in the vertical direction Z may be greater than a thickness of the first dummy impurity region 49d1' in the vertical direction Z.

In some implementations, the first dummy impurity region 49d1 and the second dummy impurity region 49d2 having substantially the same concentration of impurity as in FIG. 3 may be replaced with the first dummy impurity region 49d1' and the second dummy impurity region 49d2' having different concentrations of impurity as in FIG. 5F.

In some implementations, a concentration of impurity of the second dummy impurity region 49d2' may be higher than a concentration of impurity of the first dummy impurity region 49d1'.

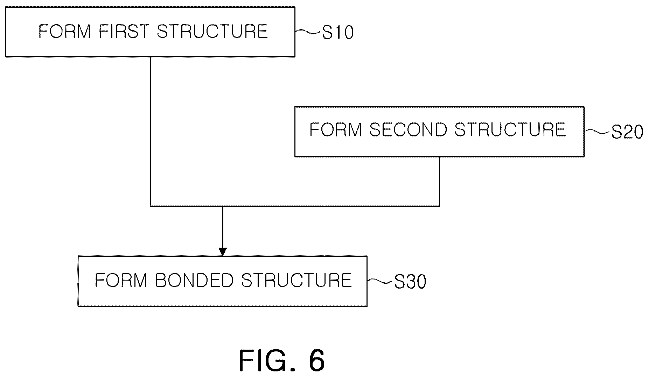

In the description below, examples of methods of manufacturing semiconductor devices (e.g., devices as described with respect to FIGS. 1, 2, 3, 4, and 5A to 5F) will be described. For example, FIG. 6 is a process flowchart illustrating an example of a method of manufacturing a semiconductor device.

Referring to FIG. 6, a method of manufacturing a semiconductor device may include forming a first structure (S10), forming a second structure (S20), and forming a bonded structure (S30). The second structure may include a peripheral circuit. Forming the bonded structure (S30) may be performed by bonding the first structure to the second structure using a wafer bonding process.

Hereinafter, an example of forming the first structure (S10), an example of forming the second structure (S20), and an example of forming the bonded structure (S30) will be described.

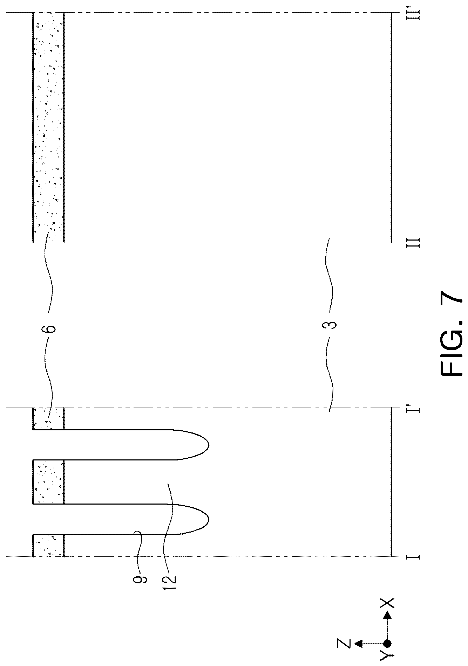

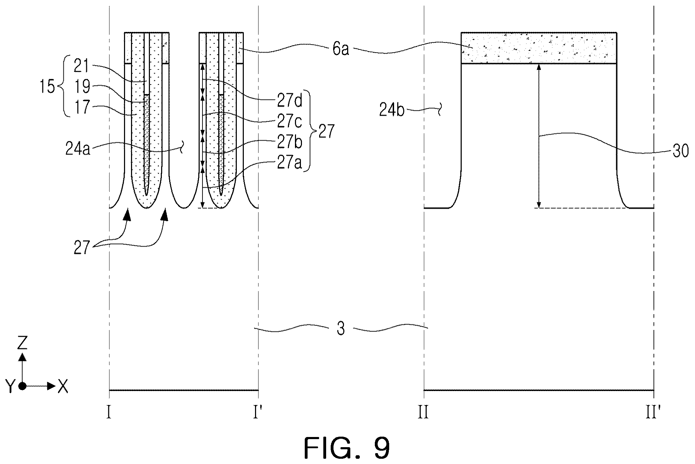

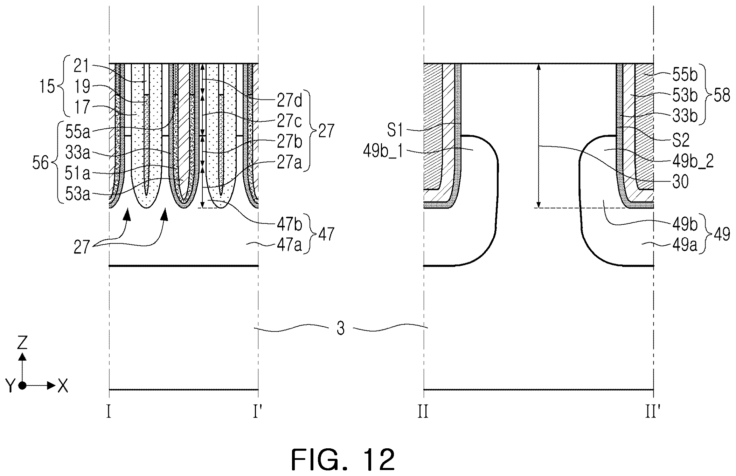

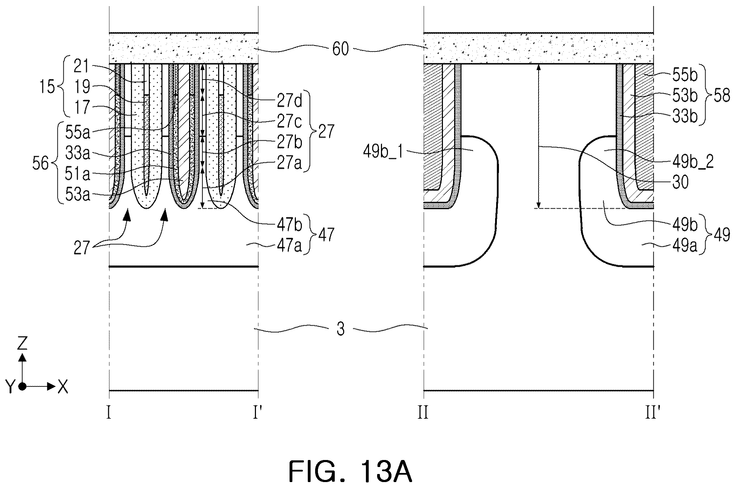

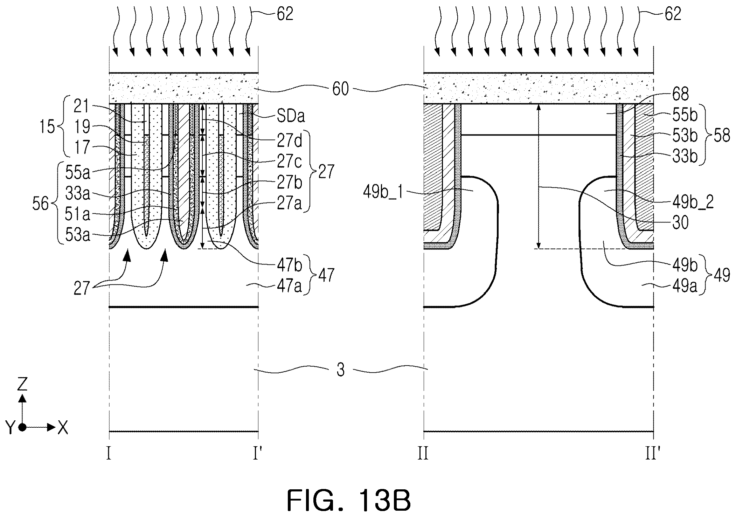

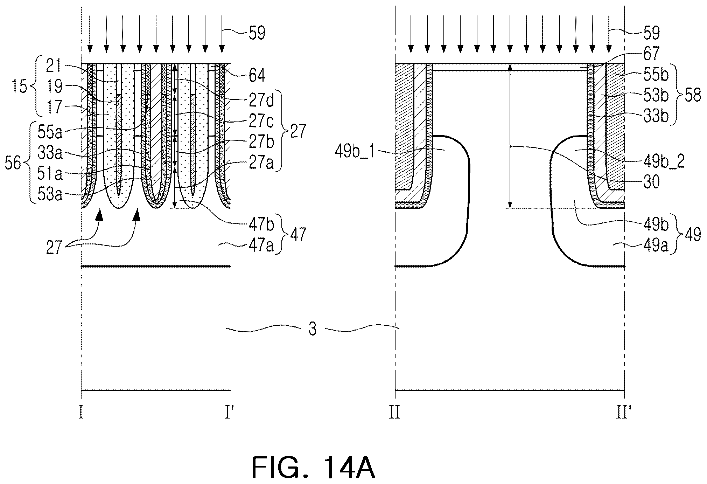

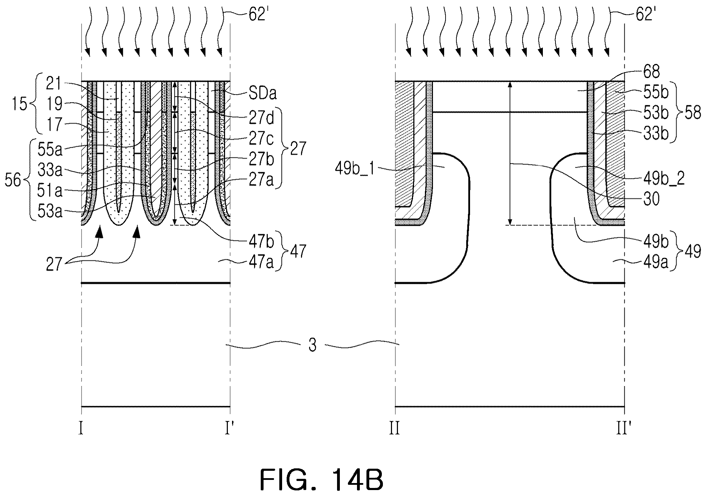

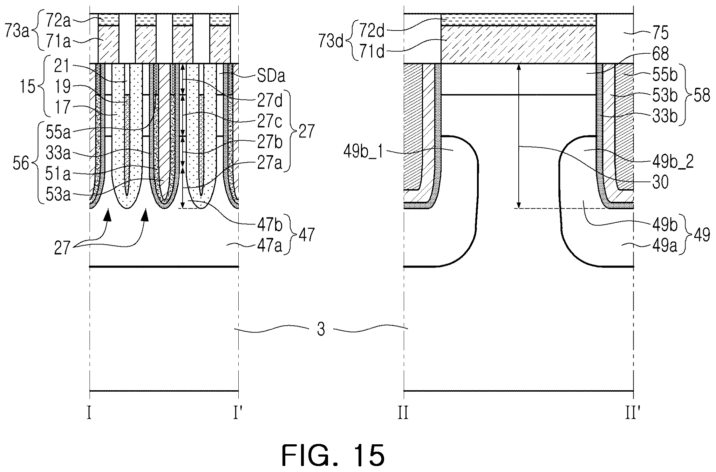

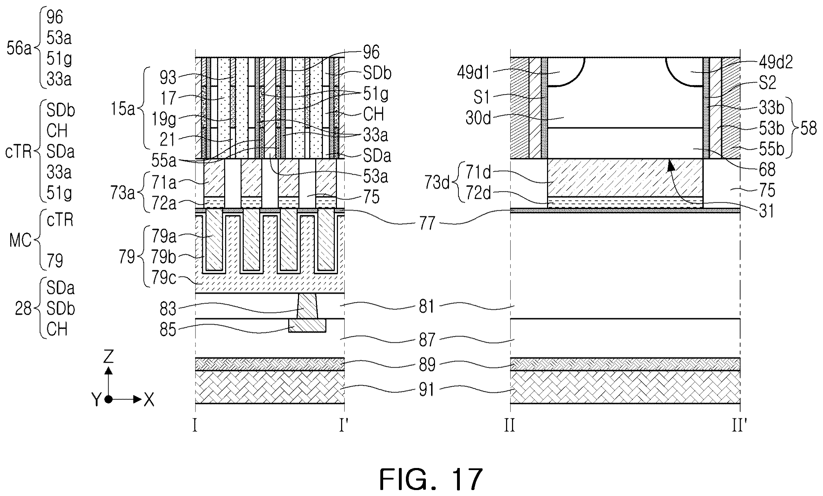

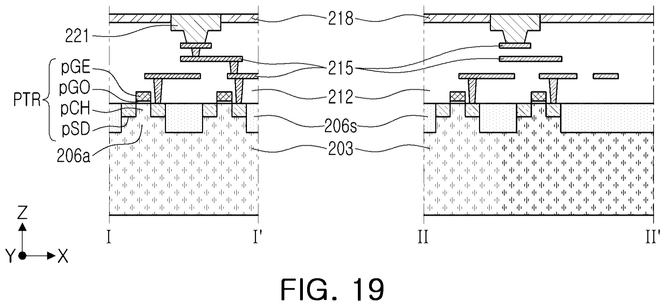

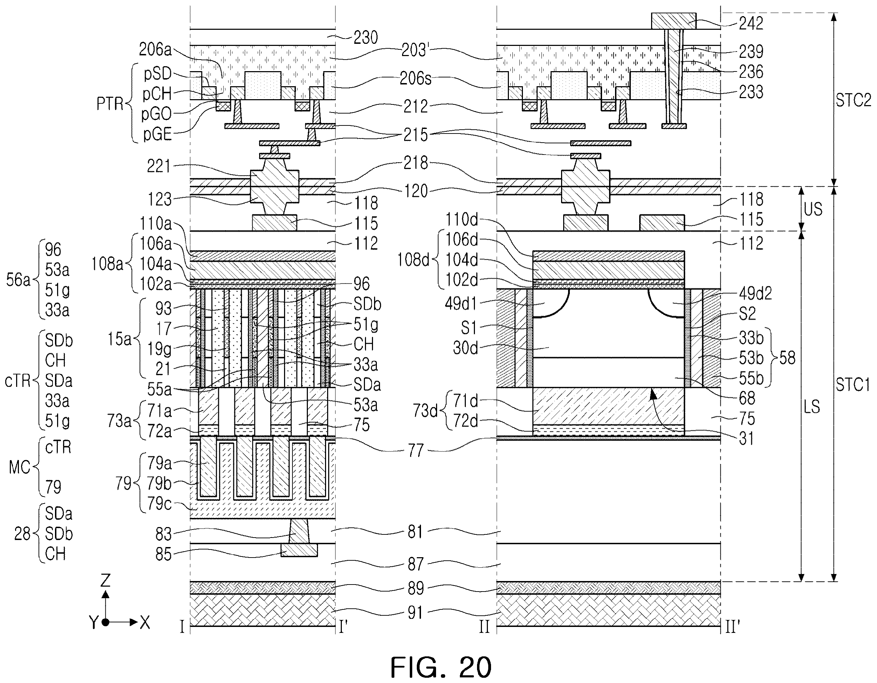

An example of forming the first structure (S10) in FIG. 6 will be described with reference to FIGS. 7, 8, 9, 10, 11, 12, FIGS. 13A and 13B, FIGS. 14A and 14B, and FIGS. 15, 16, 17, and 18. An example of forming the second structure (S20) in FIG. 6 will be described with reference to FIG. 19. An example of forming the bonded structure (S30) in FIG. 6 will be described with reference to FIG. 20. These figures are cross-sectional diagrams taken along lines I-I' and II-II' in FIG. 2. FIGS. 14A and 14B are cross-sectional diagrams illustrating an alternative example of the method in FIGS. 13A and 13B.

Referring to FIGS. 2, 6, and 7, forming the first structure (S10) may include preparing a semiconductor substrate and forming trenches 9 in the semiconductor substrate, thereby forming semiconductor lines 12 defined by the trenches 9. The semiconductor substrate may be a single-crystal silicon substrate. Side surfaces of the semiconductor lines 12 may be defined by the trenches 9.

The trenches 9 and the semiconductor lines 12 may be formed in the memory cell array region MCA.

Forming the trenches 9 and the semiconductor lines 12 may include forming a first mask pattern 6 on the semiconductor substrate, and performing an etching process using the first mask pattern 6 as an etching mask.

The trenches 9 may be formed by etching the semiconductor substrate by the etching process.

In the semiconductor substrate, the semiconductor substrate portion defined by the trenches 9 and remaining below the first mask pattern 6 may be defined as the semiconductor lines 12, and the semiconductor substrate portion disposed at a level lower than a level of the trenches 9 and the semiconductor lines 12 may be defined as the semiconductor body 3.

At least a portion of the first mask pattern 6 may be formed on the semiconductor lines 12. For example, the first mask pattern 6 may be formed on the semiconductor lines 12 in the memory cell array region MCA, and may be formed on the semiconductor substrate in the dummy region DA within the dummy region DA.

The semiconductor lines 12 may extend upwardly from the semiconductor body 3.

Referring to FIGS. 2, 6, and 8, forming the first structure (S10) may further include forming preliminary back gate structures 15 in the trenches 9.

Each of the preliminary back gate structures 15 may include a back gate dielectric layer 17 covering an inner wall of a corresponding trench 9 among the trenches 9, a preliminary back gate electrode 19 partially filling the trench 9 on the back gate dielectric layer 17, and a first back gate capping insulating layer 21 on the preliminary back gate electrode 19.

The preliminary back gate electrodes 19 may be formed of a conductive material.

Upper surfaces of the preliminary back gate electrodes 19 may be formed at a level lower than a level of upper surfaces of the semiconductor lines 12.

Upper surfaces of the preliminary back gate structures 15 may be formed at a level higher than a level of upper surfaces of the semiconductor lines 12.

Referring to FIGS. 2, 6, and 9, forming the first structure (S10) may further include forming preliminary cell semiconductor patterns 27. Forming the first structure (S10) may further include forming preliminary dummy semiconductor patterns 30.

In some implementations, the preliminary cell semiconductor patterns 27 and the preliminary dummy semiconductor patterns 30 may be formed simultaneously.

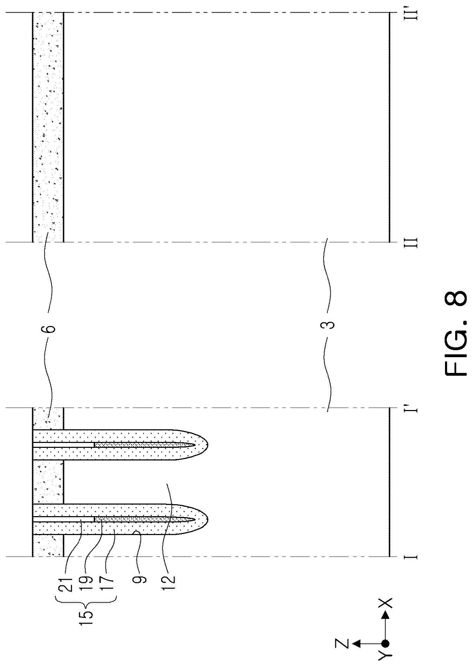

Forming the preliminary cell semiconductor patterns 27 and the preliminary dummy semiconductor pattern 30 may include forming a second mask pattern 6a on the preliminary semiconductor patterns (12 in FIG. 8) in the memory cell array region MCA and the semiconductor substrate in the dummy region DA, and etching the preliminary semiconductor patterns (12 in FIG. 8) in the memory cell array region MCA and the semiconductor substrate in the dummy region DA by an etching process using the second mask pattern 6a and the preliminary back gate structure 15 as etching masks.

The preliminary semiconductor patterns (or semiconductor lines) (12 in FIG. 8) may be etched by an etching process using the second mask pattern 6a and the preliminary back gate structure 15 as an etching mask, thereby forming first openings 24a, and the preliminary cell semiconductor patterns 27 having side surfaces exposed by the first openings 24a may be formed. The preliminary cell semiconductor patterns 27 may be formed below the second mask pattern 6a. In the preliminary cell semiconductor patterns 27, the side surfaces exposed by the first openings 24a may be defined as first side surfaces. Accordingly, each of the preliminary cell semiconductor patterns 27 may have a first side surface exposed by the first opening 24a and a second side surface in contact with the preliminary back gate structure 15. The first openings 24a and the preliminary cell semiconductor patterns 27 may be formed on the semiconductor body 3, and the preliminary cell semiconductor patterns 27 may extend upwardly from the semiconductor body 3.

By etching the semiconductor substrate in the dummy region DA by an etching process using the second mask pattern 6a as an etching mask, the second opening 24b may be formed, and the preliminary dummy semiconductor pattern 30 of which a side surface is defined by the second opening 24b may be formed. In the dummy region DA, a portion of the semiconductor substrate positioned below the second opening 24b and the preliminary dummy semiconductor pattern 30 may be defined as the semiconductor body 3. Accordingly, the second opening 24b and the preliminary dummy semiconductor pattern 30 may be formed on the semiconductor body 3, and the preliminary dummy semiconductor pattern 30 may extend upwardly from the semiconductor body 3.

Each of the preliminary cell semiconductor patterns 27 may include a lower region 27a, a first intermediate region 27b on the lower region 27a, a second intermediate region 27c on the first intermediate region 27b, and an upper region 27d on the second intermediate region 27c. In each of the preliminary cell semiconductor patterns 27, the lower region 27a may have a shape in which a width increases downwardly, and the first intermediate region 27b, the second intermediate region 27c, and the upper region 27d may have substantially the same width. In each of the preliminary cell semiconductor patterns 27, a width of the lower surface may be greater than a width of the upper surface. For example, in each of the preliminary cell semiconductor patterns 27, a maximum width in the first horizontal direction X of the lower region 27a may be greater than a maximum width in the first horizontal direction X of each of the first intermediate region 27b, the second intermediate region 27c, and the upper region 27d. In the preliminary dummy semiconductor pattern 30, a width of the lower surface may be greater than a width of the upper surface. A lower region of the preliminary dummy semiconductor pattern 30 may have a shape in which a width increases downwardly.

Referring to FIGS. 2, 6, and 10, forming the first structure (S10) may further include forming dielectric layers 33a and 33b covering inner walls of the first openings 24a and the second opening 24b and covering the second mask pattern 6a and the preliminary back gate structure 15.

In the dielectric layer 33a and 33b, a portion 33a formed in the memory cell array region MCA and covering the inner walls of the first openings 24a may be defined as a cell gate dielectric layer 33a, and a portion 33b formed in the dummy region DA and covering the inner wall of the second opening 24b may be defined as a peripheral dielectric layer 33b.

Forming the first structure (S10) may further include forming first cell impurity-implanted regions 39 and first dummy impurity-implanted regions 41 by performing a first impurity implantation process 36 for implanting first impurities.

At least a portion of each of the first cell impurity-implanted regions 39 may be formed by implanting the first impurities in the semiconductor body 3 below a corresponding first opening 24a among the first openings 24a. For example, each of the first cell impurity-implanted regions 39 may include a first region 39a formed in the semiconductor body 3 below the corresponding first opening 24a among the first openings 24a and a second region 39b formed in the lower regions 27a of the preliminary cell semiconductor patterns 27 on both sides of the first opening 24a.

At least a portion of the first dummy impurity-implanted region 41 may be formed by implanting the first impurities in the semiconductor body 3 below the second opening 24b. For example, the first dummy impurity-implanted region 41 may include a first region 41a formed in the semiconductor body 3 below the second opening 24b and a second region 41b formed in a lower region of the preliminary dummy semiconductor pattern 30.

In some implementations, the first impurity implantation process 36 may be performed after forming the dielectric layers 33a and 33b.

In some implementations, the dielectric layers 33a and 33b may be formed after performing the first impurity implantation process 36.

Referring to FIGS. 2, 6, and 11, forming the first structure (S10) may further include forming a first cell impurity-diffused region 47 and a first dummy impurity-diffused region 49 by performing first source/drain annealing 44.

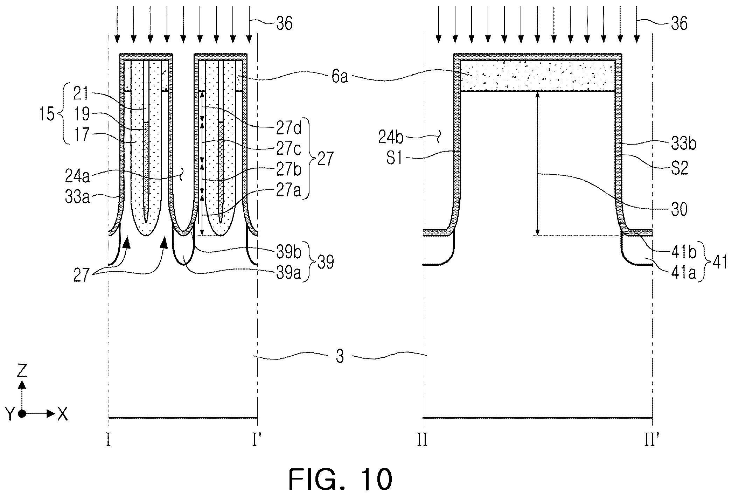

The first cell impurity-diffused region 47 may be formed by diffusion and activation of the first impurities in the first cell impurity-implanted regions (39 in FIG. 10) by the first source/drain annealing 44.

The first cell impurity-diffused region 47 may include a first portion 47a formed in the semiconductor body 3 and second portions 47b formed in the preliminary cell semiconductor patterns 27. The second portions 47b of the first cell impurity-diffused region 47 may be formed in the lower regions 27a and the first intermediate regions 27b of the preliminary cell semiconductor patterns 27. The first cell impurity-diffused region 47 may be formed by extending from a portion formed in the semiconductor body 3 to the first intermediate regions 27b of the preliminary cell semiconductor patterns 27. The first cell impurity-diffused region 47 may have an N-type conductivity.

The first dummy impurity-diffused region 49 may be formed at substantially the same level as the first cell impurity-diffused region 47. The first dummy impurity-diffused region 49 may be formed by diffusion and activation of the first impurities in the first dummy impurity-implanted region (41 in FIG. 10) by the first source/drain annealing 44. The first dummy impurity-diffused region 49 may include a first portion 49a formed in the semiconductor body 3 and a second portion 49b formed in the preliminary dummy semiconductor pattern 30.

The preliminary dummy semiconductor pattern 30 may have a first side surface S1 and a second side surface S2 opposing each other in the first horizontal direction X. The first dummy impurity-diffused region 49 may include a first dummy impurity-diffused region 49b_1 adjacent to the first side surface S1, and a second dummy impurity-diffused region 49b_2 adjacent to the second side surface S2. The first dummy impurity-diffused region 49b_1 and the second dummy impurity-diffused region 49b_2 may be spaced apart from each other in the first horizontal direction X.

Depending on a distance over which impurities in the first dummy impurity-implanted region (41 in FIG. 10) diffuse, a concentration of impurity of the first dummy impurity-diffused region 49b_1 adjacent to the second dummy impurity-diffused region 49b_2 (e.g., in a portion of the first dummy impurity-diffused region 49b_1 closer to the second dummy impurity-diffused region 49b_2 and farther from the first side surface S1) may be lower than a concentration of impurity of the first dummy impurity-diffused region 49b_1 adjacent to the first side surface S1 (e.g., in a portion of the first dummy impurity-diffused region 49b_1 farther from the second dummy impurity-diffused region 49b_2 and closer to the first side surface S1), and a concentration of impurity of the second dummy impurity-diffused region 49b_2 adjacent to the first dummy impurity-diffused region 49b_1 may be lower than a concentration of impurity of the second dummy impurity-diffused region 49b_2 adjacent to the second side surface S2.

In some implementations, to form the first dummy impurity region (49d1 in FIG. 3) and the second dummy impurity region (49d2 in FIG. 3) having a symmetrical structure in the first horizontal direction X as in FIG. 3, the second portion 49b of the first dummy impurity-diffused region 49b_1 and the second portion 49b of the second dummy impurity-diffused region 49b_2 may be formed in a symmetrical structure in the first horizontal direction X. The first dummy impurity-diffused region 49b_1 and the second dummy impurity-diffused region 49b_2 having a symmetrical structure in the first horizontal direction X as described above may be formed as the first dummy impurity region (49d1 in FIG. 3) and the second dummy impurity region (49d2 in FIG. 3) which have a symmetrical structure in the first horizontal direction X as in FIG. 3 by the process described later.

In some implementations, to form the first dummy impurity region (49d1' in FIG. 5F) and the second dummy impurity region (49d2' in FIG. 5F) having an asymmetric structure in the first horizontal direction X as in FIG. 5F, a first width in the first horizontal direction X of the second opening 24b adjacent to the first side surface S1 and a second width in the first horizontal direction X of the second opening 24b adjacent to the second side surface S2 may be configured to be different from each other, such that the second region (41b in FIG. 10) formed in the lower region of the preliminary dummy semiconductor pattern 30 by the second opening 24b adjacent to the first side surface S1 and the second region (41b in FIG. 10) formed in the lower region of the preliminary dummy semiconductor pattern 30 by the second opening 24b adjacent to the second side surface S2 may have an asymmetric structure. Accordingly, the second portion 49b of the first dummy impurity-diffused region 49b_1 and the second portion 49b of the second dummy impurity-diffused region 49b_2 may be formed as an asymmetric structure in the first horizontal direction X. For example, the amount of impurity implanted in the second region (41b in FIG. 10) formed in the lower region of the preliminary dummy semiconductor pattern 30 by the second opening 24b adjacent to the first side surface S1 and the amount of impurity implanted in the second region (41b in FIG. 10) formed in the lower region of the preliminary dummy semiconductor pattern 30 by the second opening 24b adjacent to the second side surface S2 may be different from each other, and accordingly, the second portion 49b of the first dummy impurity-diffused region 49b_1 and the second portion 49b of the second dummy impurity-diffused region 49b_2 may be formed in an asymmetric structure in the first horizontal direction X. As described above, the first dummy impurity-diffused region 49b_1 and the second dummy impurity-diffused region 49b_2 having a symmetrical structure in the first horizontal direction X may be formed as the first dummy impurity region (49d1' in FIG. 5F) and the second dummy impurity region (49d2' in FIG. 5F) having an asymmetrical structure in the first horizontal direction X as in FIG. 5F by the process described later.

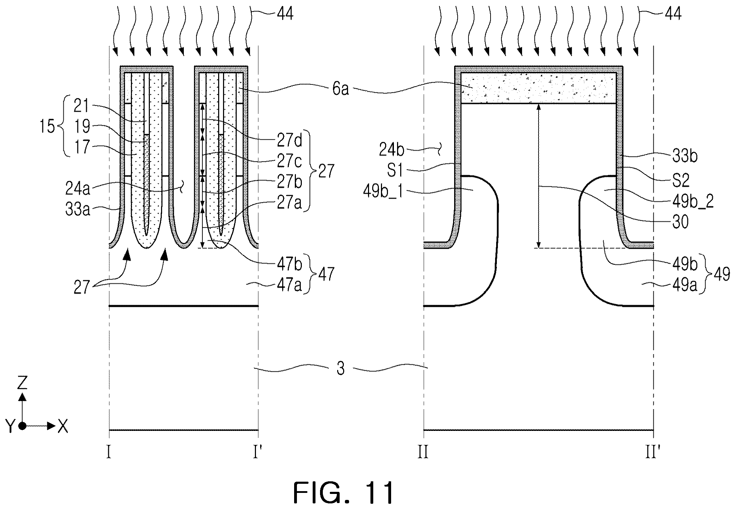

Referring to FIGS. 2, 6, and 12, forming the first structure (S10) may further include forming preliminary gate structures 56 in the first openings (24a in FIG. 11) and insulating structures 58 in the second openings (24b in FIG. 11).

Each of the preliminary gate structures 56 may include a preliminary cell gate electrode 51a, a first insulating pattern 53a, and first gate capping insulating layers 55a, together with the cell gate dielectric layer 33a.

In each of the preliminary gate structures 56, an upper surface of the first insulating pattern 53a may be formed at substantially the same level as upper surfaces of the preliminary cell semiconductor patterns 27, the preliminary cell gate electrode 51a may be disposed between the first insulating pattern 53a and the cell gate dielectric layer 33a and may have an upper surface disposed at a level lower than a level of the upper surfaces of the preliminary cell semiconductor patterns 27, and the first gate capping insulating layers 55a may be disposed on the upper surfaces of the preliminary cell gate electrode 51a positioned on both sides of the first insulating pattern 53a and may be disposed between the cell gate dielectric layer 33a and the first insulating pattern 53a.

The insulating structure 58 may include the peripheral dielectric layer 33b, an insulating liner 53b covering a surface of the peripheral dielectric layer 33b, and a second insulating pattern 55b on the insulating liner 53b.

The first insulating pattern 53a and the insulating liner 53b may be formed of a first insulating material, and the second insulating pattern 55b may be formed of a second insulating material different from the first insulating material. For example, the first insulating pattern 53a and the insulating liner 53b may be formed of silicon oxide, and the second insulating pattern 55b may be formed of silicon nitride.

While forming the preliminary gate structures 56 and the insulating structure 58, the upper surfaces of the preliminary cell semiconductor patterns 27 and the preliminary dummy semiconductor patterns 30 may be exposed. As the upper surfaces of the preliminary cell semiconductor patterns 27 and the preliminary dummy semiconductor pattern 30 are exposed, the second mask pattern 6a may be removed, and the preliminary back gate structure 15 may be formed to have an upper surface disposed substantially at the same level as the upper surfaces of the preliminary cell semiconductor patterns 27.

Referring to FIGS. 2, 6, and 13A, forming the first structure (S10) may further include forming at least one polysilicon layer 60.

Forming the at least one polysilicon layer 60 may include forming a doped polysilicon layer doped with second impurities, for example, a group 15 element in the periodic table. The group 15 element may be at least one of phosphorus (P) and arsenic (As). For example, the group 15 element may be phosphorus (P).

In some implementations, the at least one polysilicon layer 60 may be entirely doped with second impurities.

In some implementations, in the at least one polysilicon layer 60, the lower region may be an undoped region, not doped with impurities, and the upper region on the lower region may be a doped region, doped with the second impurities.

The at least one polysilicon layer 60 may be in contact with upper surfaces of the preliminary cell semiconductor patterns 27.

In some implementations, the at least one polysilicon layer 60 may be in contact with an upper surface of the preliminary dummy semiconductor pattern 30.

As another example, the at least one polysilicon layer 60 on the preliminary dummy semiconductor pattern 30 may not be provided. Accordingly, the at least one polysilicon layer 60 may be in contact with the preliminary cell semiconductor patterns 27 and may be spaced apart from the preliminary dummy semiconductor pattern 30.

Referring to FIGS. 2, 6, and 13B, forming the first structure (S10) may further include performing second source/drain annealing 62.

Performing the second source/drain annealing 62 may include forming first source/drain regions SDa by diffusing the second impurities in the at least one polysilicon layer 60 into the upper regions 27d of the preliminary cell semiconductor patterns 27 and activating the second impurities. The first source/drain regions SDa may be formed in the upper regions 27d of the preliminary cell semiconductor patterns 27.

In some implementations, when the at least one polysilicon layer 60 is formed on the preliminary dummy semiconductor pattern 30, a first dummy source/drain region 68 may be formed in the upper region of the preliminary dummy semiconductor pattern 30 by the second source/drain annealing 62.

In some implementations, when the at least one polysilicon layer 60 is not formed on the preliminary dummy semiconductor pattern 30, the first dummy source/drain region 68 may not be provided.

In some implementations, the first source/drain annealing (44 in FIG. 11) in FIG. 11 may not be performed, rather by diffusing the first impurities of the first cell impurity-implanted region (39 in FIG. 10) to the first intermediate regions 27b of the preliminary cell semiconductor patterns 27 and activating the first impurities using the second source/drain annealing 62, the first impurity-diffused region 47 may be formed. Accordingly, the first impurity-diffused region 47 may be formed simultaneously with the first source/drain regions SDa by performing the second source/drain annealing 62.

In some implementations, the first and second impurities may be the same element, for example, phosphorus (P) or arsenic (As).

In some implementations, one of the first impurity and the second impurity may be phosphorus (P) having a relatively high diffusing rate, and the other may be arsenic (As) having a relatively low diffusing rate.

In some implementations, considering the diffusion rate of the first impurities and the diffusion rate of the second impurities, an overall thickness of the at least one polysilicon layer 60 and a position of the region doped with the second impurity of the at least one polysilicon layer 60 before performing the second source/drain annealing 62 may be determined.

An alternative method of forming the first source/drain regions SDa and the first dummy source/drain region 68 will be described with reference to FIGS. 14A and 14B. In the alternative example, referring to FIG. 14A, forming the first structure (S10) may not include forming the at least one polysilicon layer (60 in FIG. 13A) described with reference to FIG. 13A and may further include performing a second impurity implantation process 59 for implanting second impurities.

By the second impurity implantation process 59, a second cell impurity-implanted region 64 may be formed in the upper region of each of the upper regions 27d of the preliminary cell semiconductor patterns 27, and a second dummy impurity-implanted region 67 may be formed in the upper region of the preliminary dummy semiconductor pattern 30.

In some implementations, forming the second dummy impurity-implanted region 67 may not be performed.

Referring to FIG. 14B, forming the first structure (S10) may further include performing a second source/drain annealing 62'. By the second source/drain annealing 62', the second impurities in the second cell impurity-implanted region 64 may diffuse and be activated such that the first source/drain regions SDa as in FIG. 13B may be formed, and the second impurities in the second dummy impurity-implanted region 67 may diffuse and be activated such that the first dummy source/drain region 68 as in FIG. 13B may be formed.

In some implementations, when forming the second dummy impurity-implanted region 67 is not performed, the first dummy source/drain region 68 may not be formed.

Referring to FIGS. 2, 6, and 15, forming the first structure (S10) may further include forming contact patterns 73a and 73d.

The contact patterns 73a and 73d may include cell contact patterns 73a connected to the preliminary cell semiconductor patterns 27 and dummy contact pattern 73d connected to the preliminary dummy semiconductor pattern 30.

The cell contact patterns 73a may be electrically connected to the first source/drain regions SDa of the preliminary cell semiconductor patterns 27.

In some implementations, the dummy contact pattern 73d may not be provided.

Each of the cell contact patterns 73a may include a polysilicon layer 71a and a conductive layer 72a stacked in order. The dummy contact pattern 73d may include a polysilicon layer 71d and a conductive layer 72d stacked in order.

In some implementations, the polysilicon layers 71a and 71d may be formed by patterning the polysilicon layer 60 in FIG. 13B.

Forming the first structure (S10) may further include forming an interlayer insulating layer 75 on side surfaces of the contact patterns 73a and 73d.

Referring to FIGS. 2, 6, and 16, forming the first structure (S10) may further include forming an insulating etching stop layer 77 covering the contact patterns 73a and 73d and the interlayer insulating layer 75.

Forming the first structure (S10) may further include forming a data storage structure 79.

The data storage structure 79 may include first electrodes 79a penetrating the etching stop layer 77, connected to the cell contact patterns 73a and extending upwardly, a dielectric layer 79b covering the first electrodes 79a and the etching stop layer 77, and a second electrode 79c covering the dielectric layer 79b. The data storage structure 79 may be cell capacitors storing data in a memory such as a DRAM.

Forming the first structure (S10) may further include forming a first insulating layer 81 on a structure including the data storage structure 79 and the etching stop layer 77, forming a contact plug 83 penetrating the first insulating layer 81 and connected to the second electrode 79c, forming an interconnection 85 connected to the contact plug 83 on the first insulating layer 81, and forming a lower insulating layer 87 covering the first insulating layer 81 and the interconnection 85.

Forming the first structure (S10) may further include bonding a structure including the lower insulating layer 87 to a handling wafer 91 using a bonding layer 89.

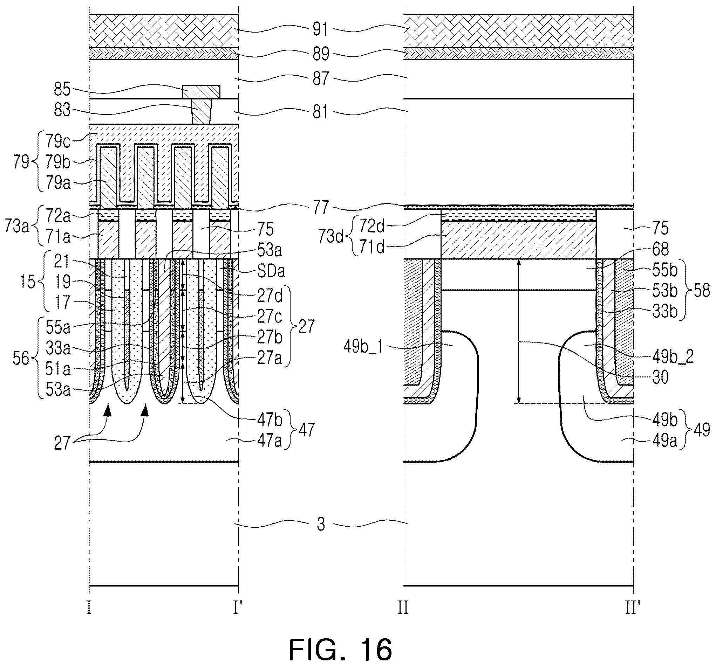

Referring to FIGS. 2, 6, and 17, forming the first structure (S10) may further include forming the preliminary cell semiconductor patterns (27 in FIG. 16) as cell semiconductor patterns 28, and forming the preliminary dummy semiconductor pattern (30 in FIG. 16) as a dummy semiconductor pattern 31.

By removing the semiconductor body (3 in FIG. 16) and simultaneously removing the lower regions (27a in FIG. 16) of the preliminary cell semiconductor patterns 27, the preliminary cell semiconductor patterns 27 may be formed as the cell semiconductor patterns 28. The lower regions (27a in FIG. 16) of the preliminary cell semiconductor patterns 27 may be removed by a planarization process.

By removing the lower regions 27a of the preliminary cell semiconductor patterns (27 in FIG. 16), the elements disposed at the same level as the lower regions 27a of the preliminary cell semiconductor patterns 27 may be removed by the planarization process.

By removing the lower region of the preliminary dummy semiconductor pattern (30 in FIG. 16) by the planarization process, the dummy semiconductor pattern 31 may be formed.

The region remaining in the first intermediate regions (27b in FIG. 16) of the preliminary cell semiconductor patterns (27 in FIG. 16) in the first cell impurity-diffused region (47 in FIG. 16) may be defined as the second source/drain regions SDb.

In the first dummy impurity-diffused region (49 in FIG. 16), after the lower region of the preliminary dummy semiconductor pattern (30 in FIG. 16) is removed, the remaining region in the dummy semiconductor pattern 31 may be defined as the second dummy source/drain region 49d1 and 49d2.

At least a portion of the second dummy source/drain region 49d1 and 49d2 may be disposed at the same level as the second source/drain regions SDb.

The dummy semiconductor pattern 31 may have a first side surface S1 and a second side surface S2 opposing each other in the first horizontal direction X, and the second dummy source/drain region 49d1 and 49d2 may include a first dummy impurity region 49d1 disposed in the dummy semiconductor pattern 31 adjacent to the first side surface S1 and a second dummy impurity region 49d2 disposed in the dummy semiconductor pattern 31 adjacent to the second side surface S2.

In some implementations, a concentration of impurity of first dummy impurity region 49d1 adjacent to the second dummy impurity region 49d2 the may be lower than a concentration of impurity of the first dummy impurity region 49d1 adjacent to the first side surface S1. A concentration of impurity of the second dummy impurity region 49d2 adjacent to the first dummy impurity region 49d1 may be lower than a concentration of impurity of the second dummy impurity region 49d2 adjacent to the second side surface S2.

In some implementations, the first dummy impurity region 49d1 may be spaced apart from the second dummy impurity region 49d2 in the first horizontal direction X.

In some implementations, when the dummy semiconductor pattern 31 is formed as a dummy semiconductor pattern (31a in FIG. 5A) having a reduced width as in FIG. 5A, the first dummy impurity region 49d1 and the second dummy impurity region 49d2 may be connected to each other as an integrated dummy impurity region (149d in FIG. 5A) in the first horizontal direction X. The dummy impurity region (149d in FIG. 5A) may have a relatively low concentration of impurity in a middle region between the first and second side surfaces S1 and S2 opposing each other in the first horizontal direction X.

Forming the first structure (S10) may further include forming the preliminary back gate structures (15 in FIG. 16) as back gate structures 15a

Forming each of the back gate structures 15a may include exposing the preliminary back gate electrode (19 in FIG. 16) by performing a planarization process for forming the cell semiconductor patterns 28 and the dummy semiconductor pattern 31, forming a back gate electrode 19g by etching a portion of the preliminary back gate electrode (19 in FIG. 16), and forming a second back gate capping insulating layer 93 in a space in which the preliminary back gate electrode (19 in FIG. 16) is partially etched.

Each of the back gate structures 15a may include the back gate dielectric layer 17, the first back gate capping insulating layer 21, the second back gate capping insulating layer 93, and the back gate electrode 19g.

Forming the first structure (S10) may further include forming the preliminary gate structures (56 in FIG. 16) as gate structures 56a.

Forming each of the gate structures 56a may include exposing the preliminary gate electrodes (51a in FIG. 16) by performing a planarization process for forming the cell semiconductor patterns 28 and the dummy semiconductor pattern 31, forming gate electrodes 51g by partially etching the preliminary gate electrodes (51a in FIG. 16), and forming second gate capping insulating layers 96 in the spaces in which the preliminary gate electrode (51a in Fig. 16) is partially etched.

Each of the gate structures 56a may include the gate dielectric layer 33a, the first gate capping insulating layers 55a, the second gate capping insulating layers 96, the first insulating pattern 53a, and the gate electrodes 51g.

In each of the cell semiconductor patterns 28, the region between the first source/drain region SDa and the second source/drain region SDb may be defined as a channel region CH.

In some implementations, each of the cell transistors cTR may include the cell gate electrode 51g, the cell gate dielectric layer 33a, the first source/drain region SDa, the second source/drain region SDb, and the channel region CH.

In some implementations, each of the memory cells MC may include the cell transistor cTR and the data storage structure 79 electrically connected to the cell transistor cTR

Referring to FIGS. 2, 6, and 18, forming the first structure STC1 (S10) may further include forming bit lines 108a on the cell semiconductor patterns 28 and a dummy conductive pattern 108d on the dummy semiconductor pattern 31.

The bit lines 108a may be connected to the cell semiconductor patterns 28. The bit lines 108a may be electrically connected to the second source/drain regions SDb of the cell semiconductor patterns 28.

The dummy conductive pattern 108d may be connected to the dummy semiconductor pattern 31.

Each of the bit lines 108a may include a first material layer 102a, a second material layer 104a, and a third material layer 106a stacked in order. The dummy conductive pattern 108d may include a first material layer 102d, a second material layer 104d, and a third material layer 106d stacked in order.

The first material layers 102a and 102d may include doped polysilicon. The second material layers 104a and 104d may include at least one of a metal nitride and a metal-semiconductor compound. The third material layers 106a and 106d may include a metal.

The bit line capping patterns 110a on the upper surfaces of the bit lines 108a and the dummy capping pattern 110d on the upper surface of the dummy conductive pattern 108d may be formed.

In some implementations, forming the dummy conductive pattern 108d and the dummy capping pattern 110d may not be performed.

Forming the first structure STC1 (S10) may further include forming a first intermediate insulating layer 112 covering the bit lines 108a, the dummy conductive pattern 108d, the bit line capping patterns 110a, and the dummy capping pattern 110d.

Forming the first structure STC1 (S10) may further include forming routing interconnections 115 on the first intermediate insulating layer 112, forming a second intermediate insulating layer 118 covering the routing interconnections 115, and forming a first bonding dielectric layer 120 on the second intermediate insulating layer 118.

In some implementations, the first bonding dielectric layer 120 may include at least one of SiO, SiN, SiCN, SiOC, SiON, or SiOCN.

Forming the first structure STC1 (S10) may further include forming a first bonding pad 123 having an upper surface coplanar with the first bonding dielectric layer 120 and electrically connected to the routing interconnections 115. The first bonding pad 123 may include a metal material, for example, copper (Cu).

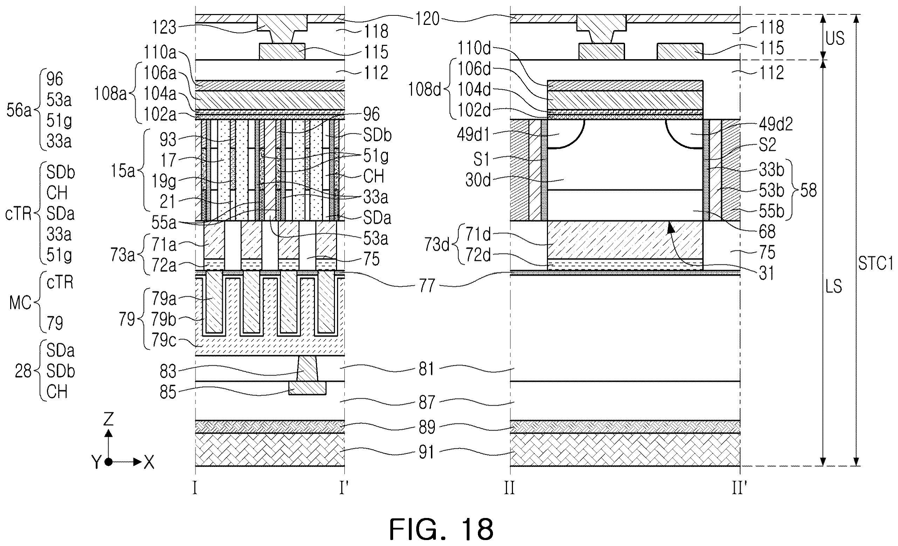

In FIG. 18, the elements from the lower insulating layer 87 to the first intermediate insulating layer 112 may be defined as a lower structure LS, and the elements on the lower structure LS may be defined as an upper structure US. The first structure STC1 may include the lower structure LS and the upper structure US. The first structure STC1 may be a first semiconductor structure STC1.

Referring to FIG. 2, FIG. 6, and FIG. 19, forming the second structure (S20) may include forming peripheral transistors PTR. Each of the peripheral transistors PTR may include peripheral source/drain regions pSD, a peripheral channel region pCH between the peripheral source/drain regions pSD, a peripheral gate electrode pGE on the peripheral channel region pCH, and a peripheral gate dielectric layer pGO between the peripheral channel region pCH and the peripheral gate electrode pGE.

In some implementations, forming the second structure (S20) may include forming peripheral device isolation regions 206s defining peripheral active regions 206a on the upper substrate 203, forming the peripheral transistors PTR', forming an upper interconnection structure 215 buried in an upper insulating layer 212 covering the peripheral transistors PTR' and electrically connected to the peripheral transistors PTR, forming a second bonding dielectric layer 218 on the upper insulating layer 212, and forming second bonding pads 221.

In each of the peripheral transistors PTR, the peripheral source/drain regions pSD and the peripheral channel region pCH may be formed in a corresponding peripheral active region 206a of the peripheral active regions 206a, and the peripheral gate dielectric layer pGO and the peripheral gate electrode pGE may be formed on the peripheral channel region pCH in the peripheral active region 206a.

The second bonding pads 221 may include a metal material, for example, copper (Cu). The second bonding pads 221 may have upper surfaces coplanar with an upper surface of the second bonding dielectric layer 218 and may be electrically connected to the upper interconnection structure 215.

In some implementations, the second bonding dielectric layer 218 may include at least one of SiO, SiN, SiCN, SiOC, SiON, or SiOCN.

Referring to FIGS. 2, 6, and 20, forming the bonded structure (S30) may include performing a hybrid bonding process including metal-metal bonding and dielectric-dielectric bonding. For example, forming the bonded structure (S30) may include bonding the first bonding pads 123 to the second bonding pads 221 while simultaneously bonding the first bonding dielectric layer 120 to the second bonding dielectric layer 218.

In some implementations, forming the bonded structure (S30) may include performing the hybrid bonding process, forming an upper substrate 203' having a reduced thickness by reducing a thickness of the upper substrate 203, forming a capping insulating layer 230 on the upper substrate 203' having a reduced thickness, forming holes 233 penetrating the capping insulating layer 230 and the upper substrate 203' having a reduced thickness and exposing the upper interconnection structure 215, forming insulating spacers 236 on side surfaces of the holes 233, forming conductive vias 239 in the holes 233, and forming input/output pads 242 on the conductive vias 239. The conductive vias 239 may be electrically connected to the upper interconnection structure 215.

Referring back to FIGS. 2 and 3, the bonding layer 89 and the handling wafer 91 may be removed. Subsequently, a semiconductor device 1 may be formed by performing a semiconductor process including a packaging process.

Hereinafter, examples of alternatives or modifications to the foregoing methods will be described. Features and operations of the examples described below and the examples described above may be combined to provide various manufacturing methods within the scope of this disclosure.

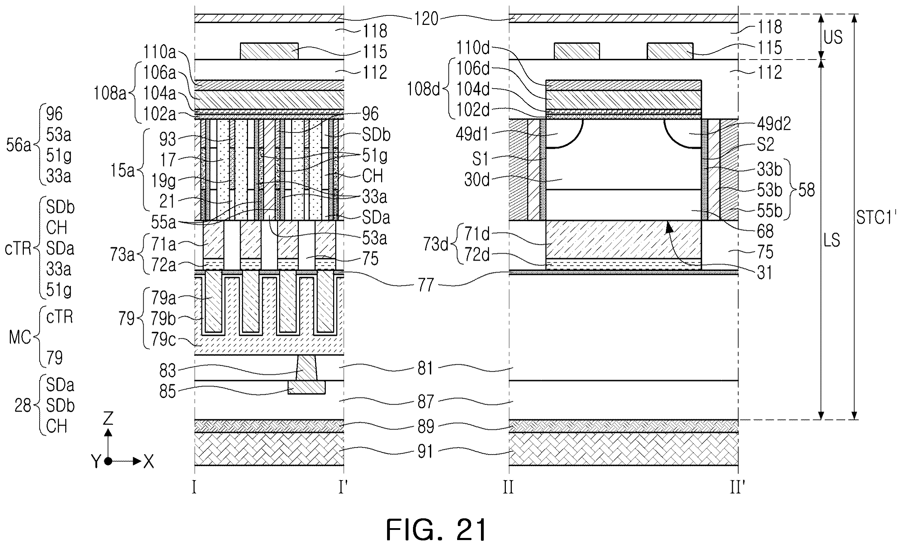

FIGS. 21, 22, and 23 are cross-sectional diagrams taken along lines I-I' and II-II' in FIG. 2.

Referring to FIGS. 2, 6, and 21, after forming the first bonding dielectric layer 120 in FIG. 18, forming the first bonding pad 123 in FIG. 18 may not be performed. Accordingly, the first structure described with reference to FIG. 18, that is, the first semiconductor structure STC1, may be formed as the first semiconductor structure STC1' of FIG. 21, not including the first bonding pad 123, e.g., as described with respect to FIG. 4.

Referring to FIGS. 2, 6, and 22, forming the second structure (S20) may include forming peripheral transistors PTR'. Each of the peripheral transistors PTR' may include peripheral source/drain regions pSD, a peripheral channel region pCH between the peripheral source/drain regions pSD, a peripheral gate electrode pGE on the peripheral channel region pCH, and a peripheral gate dielectric layer pGO between the peripheral channel region pCH and the peripheral gate electrode pGE.

In some implementations, forming the second structure (S20) may include forming peripheral device isolation regions 306s defining peripheral active regions 306a on the upper substrate 303, forming the peripheral transistors PTR', forming a front insulating layer 312 covering the peripheral transistors PTR', reducing a thickness of the upper substrate 303, forming a backside insulating layer 315 covering a back surface of the upper substrate 303, and forming a second bonding dielectric layer 318 covering the backside insulating layer 315.

In each of the peripheral transistors PTR', the peripheral source/drain regions pSD and the peripheral channel region pCH may be formed in a corresponding peripheral active region 306a among the peripheral active regions 306a, and the peripheral gate dielectric layer pGO and the peripheral gate electrode pGE may be formed on the peripheral channel region pCH in the peripheral active region 306a.

In some implementations, the second bonding dielectric layer 318 may include at least one of SiO, SiN, SiCN, SiOC, SiON, or SiOCN.

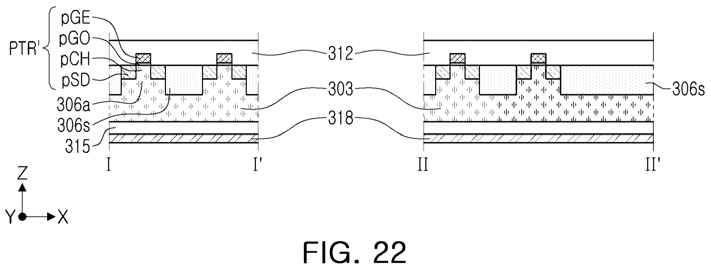

Referring to FIGS. 2, 6, and 23, forming the bonded structure (S30) may include bonding the structure formed by forming the first structure (S10) described above to the structure formed by forming the second structure (S20) described above. For example, forming the bonded semiconductor structure (S30) may include bonding the first bonding dielectric layer 120 in FIG. 21 to the second bonding dielectric layer 318 in FIG. 22 by performing a dielectric-dielectric bonding process. Accordingly, the first bonding dielectric layer 120 and the second bonding dielectric layer 318 may be bonded, thereby forming a bonded region.

In some implementations, forming the bonded structure (S30) may include forming holes 333 penetrating the front insulating layer 312 and the upper substrate 303, extending downwardly and exposing the routing interconnections 115, forming insulating spacers 336 on side surfaces of the holes 333, and forming conductive vias 339 in the holes 333. The conductive vias 339 may be electrically connected to the routing interconnections 115.

In some implementations, forming the bonded structure (S30) may further include forming contact plugs 321 penetrating the front insulating layer 312 and electrically connected to the peripheral transistors PTR'.

In some implementations, forming the bonded structure (S30) may further include forming an upper interconnection structure 327 buried in the upper insulating layer 324 and forming input/output pads 342 electrically connected to the upper interconnection structure 327. The upper interconnection structure 327 may be formed on the front insulating layer 312 and may be electrically connected to the contact plugs 321 and the conductive vias 320.

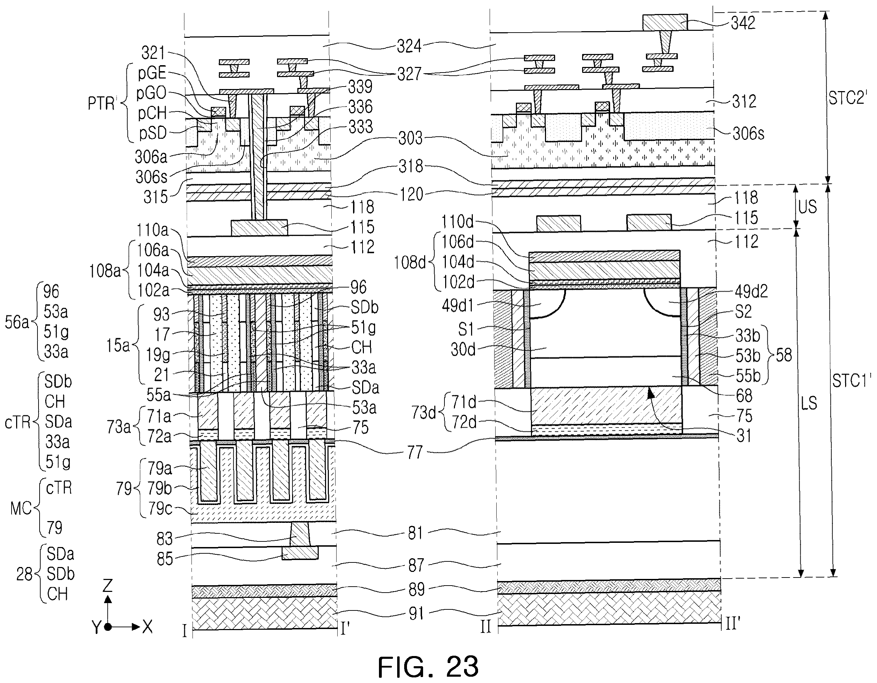

In some implementations, the structure from the lower insulating layer 87 to the first bonding dielectric layer 120 may be defined as a first semiconductor structure STC1' with reference to FIG. 23, and the structure from the first bonding dielectric layer 120 to the input/output pads 342 may be defined as a second semiconductor structure STC2'.

In some implementations, referring to FIG. 23, in the first semiconductor structure STC1', the structure from the lower insulating layer 87 to the first intermediate insulating layer 112 may be defined as a lower structure LS, and the structure on the lower structure LS may be defined as an upper structure US.

Again, referring to FIG. 2 and FIG. 4, the bonding layer 89 and the handling wafer 91 may be removed. Subsequently, by performing a semiconductor process including a packaging process, a semiconductor device 1 may be formed.

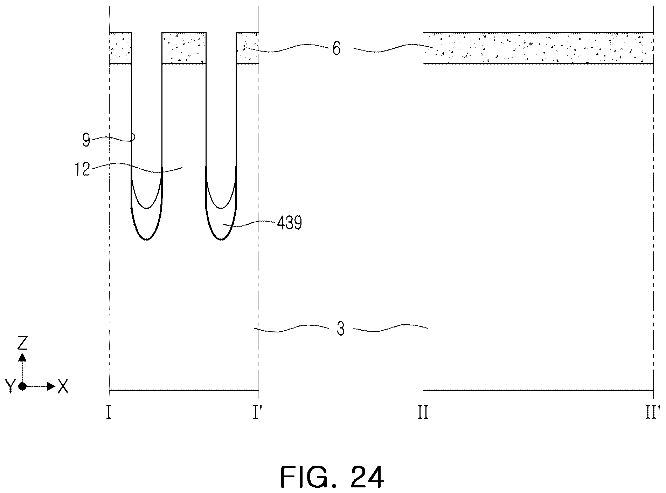

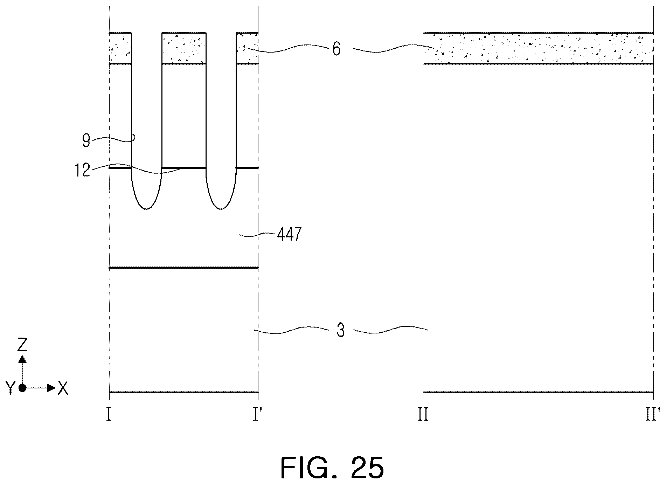

Another example of a method of manufacturing a semiconductor device (e.g., semiconductor device 1) will be described with reference to FIGS. 2 and 6 and FIGS. 24 and 25. FIGS. 24 and 25 are cross-sectional diagrams taken along lines I-I' and II-II' in FIG. 2.

Referring to FIGS. 2, 6, and 24, forming the first structure (S10) may include performing the first impurity implantation process (36 in FIG. 10) described with reference to FIG. 10 after forming the trenches 9 described with reference to FIG. 7. Accordingly, after forming the trenches 9 as described with reference to FIG. 7, by performing the first impurity implantation process (36 in FIG. 10) of implanting substantially the same first impurities described with reference to FIG. 10, first cell impurity-implanted regions 439 may be formed in lower regions of the semiconductor body 3 and the semiconductor lines 12 below the trenches 9.

Referring to FIGS. 2, 6, and 25, forming the first structure (S10) may include performing the first source/drain annealing (44 in FIG. 11) described with reference to FIG. 11 after forming the first cell impurity-implanted regions (439 in FIG. 24). By performing the first source/drain annealing (44 in FIG. 11) after forming the first cell impurity-implanted regions (439 in FIG. 24), the first impurities in the first cell impurity-implanted regions (439 in FIG. 24) may be diffused and activated and may be formed as a first impurity-diffused region 447. The first impurity-diffused region 447 may replace the first impurity-diffused region (47 in FIG. 11) described with reference to FIG. 11, and the first impurity-diffused region 447 may be formed at substantially the same level as the first impurity-diffused region (47 in FIG. 11).

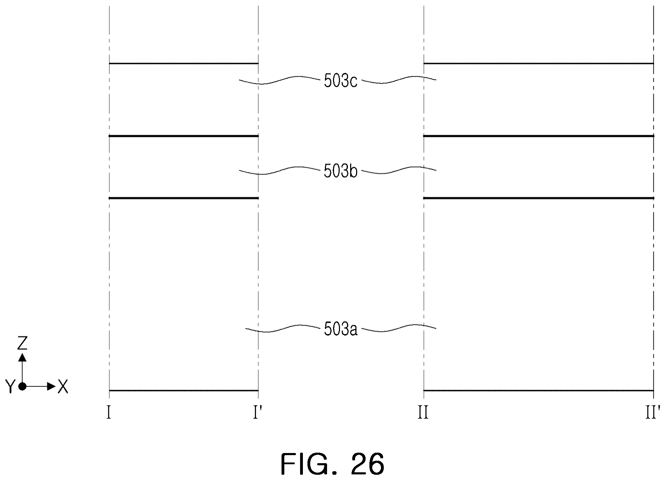

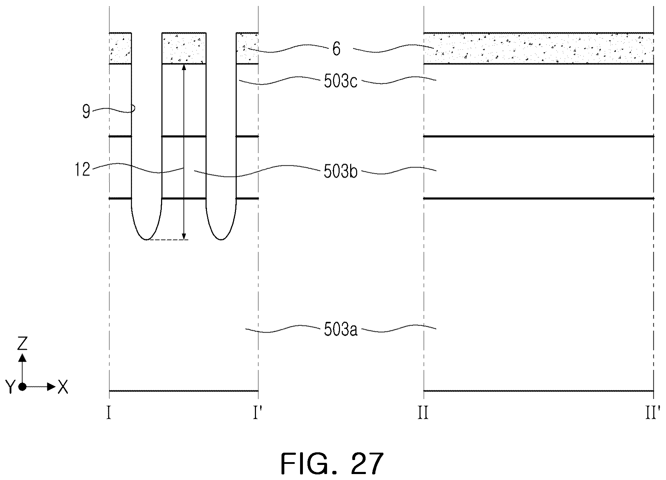

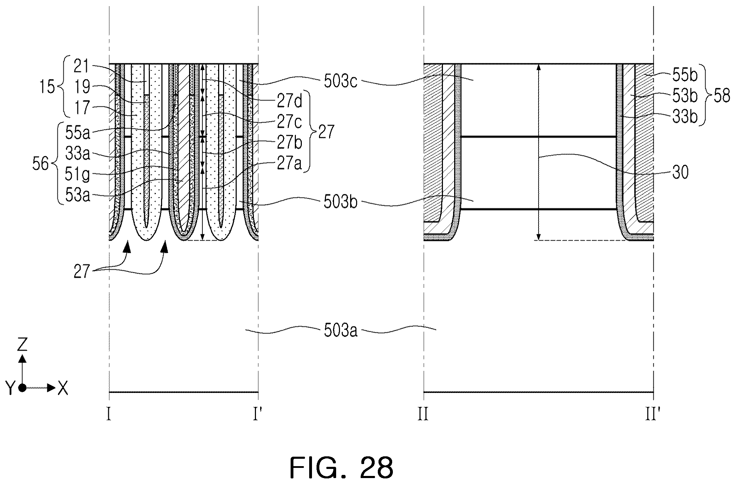

Another example of a method of manufacturing a semiconductor device (e.g., semiconductor device 1) will be described with reference to FIGS. 2 and 6, and FIGS. 26, 27, and 28. FIGS. 26, 27, and 28 are cross-sectional diagrams taken along lines I-I' and II-II' in FIG. 2.

Referring to FIGS. 2, 6, and 26, forming the first structure (S10) may include, instead of performing the first impurity implantation process 36 and the first source/drain annealing 44 described above, forming a first impurity-implanted region by performing a first impurity implantation process of implanting first impurities into a semiconductor substrate which may be formed of single-crystal silicon, and forming a first impurity-diffused region 503b by diffusing and activating the first impurities in the first impurity-implanted region by performing the first source/drain annealing. Accordingly, the semiconductor substrate 503a, 503b, and 503c may include a first semiconductor region 503a below the first impurity-diffused region 503b and a second semiconductor region 503c on the first impurity-diffused region 503b.

Subsequently, the trenches 9 and the semiconductor lines 12 described with reference to FIG. 7 may be formed.

In some implementations, the trenches 9 may penetrate the first impurity-diffused region 503b.

As another example, the first impurity-diffused region 503b may extend downwardly through the trenches 9.

Referring to FIGS. 2, 6, and 26 to 28, forming the first structure (S10) may include forming the preliminary back gate structures 15, the preliminary cell semiconductor patterns 27, the preliminary dummy semiconductor pattern 30, and the preliminary gate structures 56 described above.

The first impurity-diffused region 503b may be formed in a portion of the lower region 27a and the first intermediate region 27b of each of the preliminary cell semiconductor patterns 27 described above, but configurations within the scope of this disclosure are not limited thereto. For example, in the case in which the first impurity-diffused region 503b is formed such that the trenches 9 extend downwardly, the first impurity-diffused region 503b may be formed in the same shape as that of the first impurity-diffused region (47 in FIG. 11) described with reference to FIG. 11.

The first impurity-diffused region 503b may be formed as the second source/drain regions (SDb in FIG. 5D) described above with reference to FIG. 5D and the second dummy source/drain region (249d in FIG. 5D) described above with reference to FIG. 5D.

The above description provides various examples of semiconductor devices. For example, a semiconductor device may include a cell semiconductor pattern including a first source/drain region, a second source/drain region on the first source/drain region, and a channel region between the first source/drain region and the second source/drain region; and a dummy semiconductor pattern disposed at the same level as the cell semiconductor pattern and electrically isolated. The dummy semiconductor pattern may include an upper dummy source/drain region. The dummy semiconductor pattern may have a first side surface and a second side surface opposing each other in a first horizontal direction. The upper dummy source/drain region may include a first dummy impurity region formed in the dummy semiconductor pattern adjacent to the first side surface and a second dummy impurity region formed in the dummy semiconductor pattern adjacent to the second side surface. The first dummy impurity region may be spaced apart from the second dummy impurity region in the first horizontal direction.

At least a portion of the upper dummy source/drain region may be disposed at the same level as the second source/drain region.

In the upper dummy source/drain region, a concentration of impurity of the first dummy impurity region adjacent to the second dummy impurity region may be lower than a concentration of impurity of the first dummy impurity region adjacent to the first side surface.

The semiconductor device may further include a cell gate electrode opposing the channel region.

The semiconductor device may further include a back gate electrode opposing the cell gate electrode with the channel region interposed therebetween.

The semiconductor device may further include a cell contact pattern connected to the first source/drain region; a data storage structure connected to the cell contact pattern; and a bit line connected to the second source/drain region.

The dummy semiconductor pattern may further include a lower dummy source/drain region disposed at a level lower than a level of the upper dummy source/drain region.

At least a portion of the upper dummy source/drain region may be disposed at the same level as the second source/drain region, and at least a portion of the lower dummy source/drain region may be disposed at the same level as the first source/drain region.

The semiconductor device may further include a dummy contact pattern disposed at the same level as the cell contact pattern and connected to the dummy semiconductor pattern.

The semiconductor device may further include a dummy conductive pattern disposed at the same level as the bit line and connected to the dummy semiconductor pattern.

According to some implementations of the present disclosure, a method of performing an impurity implantation process and source/drain annealing after forming an opening or a trench may be provided. Using this method, the channel region of the cell transistor may be prevented from being damaged by an ion implant process.

Also, in some implementations, by performing source/drain annealing after forming an impurity-implanted region in a semiconductor body below an opening or a trench, a formed source/drain regions may be formed to have a reliable and stable junction profile and doping profile of impurities.

As a result, cell transistors including the source/drain regions formed according to the foregoing processes may have improved leakage current properties.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While various examples have been illustrated and described above, it will be apparent to those skilled in the art that modifications and variations could be made without departing from the scope of the present disclosure.

## Claims

1. A method of manufacturing a semiconductor device (1), the method comprising:
forming a first semiconductor pattern (27) on a semiconductor body (3), wherein the first semiconductor pattern (27) has a first side surface facing a first opening (24a), and the first semiconductor pattern (27) includes a lower region (27a), a first intermediate region (27b) on the lower region (27a), a second intermediate region (27c) on the first intermediate region (27b), and an upper region (27d) on the second intermediate region (27c);
implanting (36) first impurities into the semiconductor body (3) below the first opening (24a), to form a first impurity-implanted region (39) having at least a portion in the semiconductor body (3) below the first opening (24a);
annealing (44) the first impurity-implanted region (39) to form a first impurity-diffused region (47) in which the first impurities of the first impurity-implanted region (39) are diffused and activated, wherein the first impurity-diffused region (47) is in the semiconductor body (3) and in the lower region (27a) and the first intermediate region (27b) of the first semiconductor pattern (27); and
forming a first source/drain region (SDa) in which second impurities are diffused and activated in the upper region (27d) of the first semiconductor pattern (27).

2. The method of claim 1, further comprising:
forming a data storage structure (79) connected to the first source/drain region (SDa);
exposing the first intermediate region (27b) of the first semiconductor pattern (27) by removing the lower region (27a) of the first semiconductor pattern (27) and the semiconductor body (3);
forming a second source/drain region (SDb) from a remaining portion of the first impurity-diffused region (47) in the first intermediate region (27b); and
forming a bit line (108a) connected to the second source/drain region (SDb).

3. The method of claim 2, comprising:
forming a first preliminary gate structure (56) in the first opening (24a); and
after removing the semiconductor body (3) and the lower region (27a) of the first semiconductor pattern (27), forming the first preliminary gate structure (56) into a gate structure (56a).

4. The method of claim 3, wherein the first preliminary gate structure (56) includes a gate dielectric layer (33a) covering an inner wall of the first opening (24a), a first gate capping insulating pattern (55a) in the first opening (24a), and a preliminary gate electrode (51a) between the gate dielectric layer (33a) and the first gate capping insulating pattern (55a).

5. The method of claim 4, wherein the preliminary gate electrode (51a) is at a level lower than a level of the upper region (27d) of the first semiconductor pattern (27).

6. The method of claim 4 or 5, wherein forming the gate structure (56a) includes:
while removing the lower region (27a) of the first semiconductor pattern (27) and the semiconductor body (3), removing a portion of the first preliminary gate structure (56) positioned at a level lower than a level of the first intermediate region (27b) of the first semiconductor pattern (27), to form a second preliminary gate structure;
forming a gate electrode (51g) by partially etching the preliminary gate electrode (51a) of the second preliminary gate structure; and
forming a gate capping insulating layer (96) in a space from which the preliminary gate electrode (51a) has been removed.

7. The method of any of claims 3 to 6, wherein forming the first semiconductor pattern (27) includes:
forming a semiconductor structure;
forming a first mask pattern (6) on the semiconductor structure; and
etching the semiconductor structure by a first etching process using the first mask pattern (6) as an etching mask to form the first opening (24a), such that the first opening (24a) exposes the first side surface of the first semiconductor pattern (27).

8. The method of claim 7, wherein forming the semiconductor structure includes:
forming a trench (9) in a semiconductor substrate, to form a semiconductor line (12) defined by the trench (9); and
forming a preliminary back gate structure (15) in the trench (9), and
wherein a portion of the semiconductor substrate is below the trench (9) and the semiconductor line (12) comprises the semiconductor body (3).

9. The method of claim 8, wherein the preliminary back gate structure (15) includes a back gate dielectric layer (17) covering an inner wall of the trench (9), a preliminary back gate electrode (19) on the back gate dielectric layer (17) and partially filling the trench (9), and a first back gate capping insulating layer (21) on the preliminary back gate electrode (19).

10. The method of claim 8 or 9, wherein at least a portion of the first mask pattern (6) is formed on the semiconductor line (12), and
wherein the semiconductor line (12) is etched by the first etching process to form the first semiconductor pattern (27).

11. The method of any of claims 8 to 10, comprising:
after removing the lower region (27a) of the first semiconductor pattern (27), forming the preliminary back gate structure (15) into a back gate structure (15a).

12. The method of any preceding claim, wherein forming the first source/drain region (SDa) includes:
forming a polysilicon layer (60) in contact with the upper region (27d) of the first semiconductor pattern (27) and doped with the second impurities; and
performing a first source/drain annealing (62) to diffuse the second impurities in the polysilicon layer (60) into the upper region (27d) of the first semiconductor pattern (27) and activate the second impurities.

13. The method of claim 12, wherein the first source/drain annealing (62) comprises the annealing (44) to form the first impurity-diffused region (47).

14. The method of claim 12, wherein the first source/drain region (SDa) is formed after the first impurity-diffused region (47) is formed.

15. The method of any of claims 1 to 11, wherein forming the first source/drain region (SDa) includes:
forming a second impurity-implanted region (64) by implanting (59) the second impurities into a portion of the upper region (27d) of the first semiconductor pattern (27); and
performing a first source/drain annealing (62') to diffuse the second impurities of the second impurity-implanted region (64) into the upper region (27d) of the first semiconductor pattern (27) and activate the second impurities.
